# EUROPEAN PATENT APPLICATION

(11) **EP 4 276 218 A1**
(43) Date of publication of application: **15.11.2023**
(21) Application number: 23172404.8
(22) Date of filing: 09.05.2023
(51) Int. Cl.: C23C 14/04, C23C 14/12, C23C 14/22, C23C 14/24, C23C 14/50, C23C 14/54, H10K 71/00

(54) **ORGANIC VAPOR JET PRINTING SYSTEM**

(30) Priority: 09.05.2022 US 202263339940 P; 03.05.2023 US 202318311519
(71) Applicant: Universal Display Corporation, Ewing, NJ 08618 (US)
(72) Inventor: HAWTHORNE, Jeff, Ewing, 08618 (US); QUINN, William, Ewing, 08618 (US); NGUYEN, Kent Khuong, Ewing, 08618 (US); KRISHNASWAMI, Sriram, Ewing, 08618 (US); MCGRAW, Gregory, Ewing, 08618 (US); TOET, Daniel, Ewing, 08618 (US)
(74) Representative: Maiwald GmbH

(57) **Abstract**

Methods, systems, and devices are provided for organic vapor jet deposition (OVJP), which require significantly fewer print heads than conventional OVJP deposition systems. The disclosed OVJP systems include half the number of OVJP print heads than a conventional system, or less, and provide for relative movement of the substrate and print heads to allow for rapid and comprehensive material deposition over the full surface of the substrate.

## Description

### FIELD

The present invention relates to devices and techniques for performing organic vapor jet printing (OVJP), such as for fabricating organic emissive devices including organic light emitting diodes, and devices and techniques including the same.

### BACKGROUND

Opto-electronic devices that make use of organic materials are becoming increasingly desirable for a number of reasons. Many of the materials used to make such devices are relatively inexpensive, so organic opto-electronic devices have the potential for cost advantages over inorganic devices. In addition, the inherent properties of organic materials, such as their flexibility, may make them well suited for particular applications such as fabrication on a flexible substrate. Examples of organic opto-electronic devices include organic light emitting diodes/devices (OLEDs), organic phototransistors, organic photovoltaic cells, and organic photodetectors. For OLEDs, the organic materials may have performance advantages over conventional materials. For example, the wavelength at which an organic emissive layer emits light may generally be readily tuned with appropriate dopants.

OLEDs make use of thin organic films that emit light when voltage is applied across the device. OLEDs are becoming an increasingly interesting technology for use in applications such as flat panel displays, illumination, and backlighting. Several OLED materials and configurations are described in U.S. Pat. Nos. 5,844,363, 6,303,238, and 5,707,745, which are incorporated herein by reference in their entirety.

One application for phosphorescent emissive molecules is a full color display. Industry standards for such a display call for pixels adapted to emit particular colors, referred to as "saturated" colors. In particular, these standards call for saturated red, green, and blue pixels. Alternatively the OLED can be designed to emit white light. In conventional liquid crystal displays emission from a white backlight is filtered using absorption filters to produce red, green and blue emission. The same technique can also be used with OLEDs. The white OLED can be either a single EML device or a stack structure. Color may be measured using CIE coordinates, which are well known to the art.

As used herein, the term "organic" includes polymeric materials as well as small molecule organic materials that may be used to fabricate organic opto-electronic devices. "Small molecule" refers to any organic material that is not a polymer, and "small molecules" may actually be quite large. Small molecules may include repeat units in some circumstances. For example, using a long chain alkyl group as a substituent does not remove a molecule from the "small molecule" class. Small molecules may also be incorporated into polymers, for example as a pendent group on a polymer backbone or as a part of the backbone. Small molecules may also serve as the core moiety of a dendrimer, which consists of a series of chemical shells built on the core moiety. The core moiety of a dendrimer may be a fluorescent or phosphorescent small molecule emitter. A dendrimer may be a "small molecule," and it is believed that all dendrimers currently used in the field of OLEDs are small molecules.

As used herein, "top" means furthest away from the substrate, while "bottom" means closest to the substrate. Where a first layer is described as "disposed over" a second layer, the first layer is disposed further away from substrate. There may be other layers between the first and second layer, unless it is specified that the first layer is "in contact with" the second layer. For example, a cathode may be described as "disposed over" an anode, even though there are various organic layers in between.

As used herein, "solution processible" means capable of being dissolved, dispersed, or transported in and/or deposited from a liquid medium, either in solution or suspension form.

A ligand may be referred to as "photoactive" when it is believed that the ligand directly contributes to the photoactive properties of an emissive material. A ligand may be referred to as "ancillary" when it is believed that the ligand does not contribute to the photoactive properties of an emissive material, although an ancillary ligand may alter the properties of a photoactive ligand.

As used herein, and as would be generally understood by one skilled in the art, a first "Highest Occupied Molecular Orbital" (HOMO) or "Lowest Unoccupied Molecular Orbital" (LUMO) energy level is "greater than" or "higher than" a second HOMO or LUMO energy level if the first energy level is closer to the vacuum energy level. Since ionization potentials (IP) are measured as a negative energy relative to a vacuum level, a higher HOMO energy level corresponds to an IP having a smaller absolute value (an IP that is less negative). Similarly, a higher LUMO energy level corresponds to an electron affinity (EA) having a smaller absolute value (an EA that is less negative). On a conventional energy level diagram, with the vacuum level at the top, the LUMO energy level of a material is higher than the HOMO energy level of the same material. A "higher" HOMO or LUMO energy level appears closer to the top of such a diagram than a "lower" HOMO or LUMO energy level.

As used herein, and as would be generally understood by one skilled in the art, a first work function is "greater than" or "higher than" a second work function if the first work function has a higher absolute value. Because work functions are generally measured as negative numbers relative to vacuum level, this means that a "higher" work function is more negative. On a conventional energy level diagram, with the vacuum level at the top, a "higher" work function is illustrated as further away from the vacuum level in the downward direction. Thus, the definitions of HOMO and LUMO energy levels follow a different convention than work functions.

Layers, materials, regions, and devices may be described herein in reference to the color of light they emit. In general, as used herein, an emissive region that is described as producing a specific color of light may include one or more emissive layers disposed over each other in a stack.

As used herein, a "red" layer, material, region, or device refers to one that emits light in the range of about 580-700nm or having a highest peak in its emission spectrum in that region. Similarly, a "green" layer, material, region, or device refers to one that emits or has an emission spectrum with a peak wavelength in the range of about 500-600nm; a "blue" layer, material, or device refers to one that emits or has an emission spectrum with a peak wavelength in the range of about 400-500nm; and a "yellow" layer, material, region, or device refers to one that has an emission spectrum with a peak wavelength in the range of about 540-600nm. In some arrangements, separate regions, layers, materials, regions, or devices may provide separate "deep blue" and a "light blue" light. As used herein, in arrangements that provide separate "light blue" and "deep blue", the "deep blue" component refers to one having a peak emission wavelength that is at least about 4nm less than the peak emission wavelength of the "light blue" component. Typically, a "light blue" component has a peak emission wavelength in the range of about 465-500nm, and a "deep blue" component has a peak emission wavelength in the range of about 400-470nm, though these ranges may vary for some configurations. Similarly, a color altering layer refers to a layer that converts or modifies another color of light to light having a wavelength as specified for that color. For example, a "red" color filter refers to a filter that results in light having a wavelength in the range of about 580-700nm. In general, there are two classes of color altering layers: color filters that modify a spectrum by removing unwanted wavelengths of light, and color changing layers that convert photons of higher energy to lower energy. A component "of a color" refers to a component that, when activated or used, produces or otherwise emits light having a particular color as previously described. For example, a "first emissive region of a first color" and a "second emissive region of a second color different than the first color" describes two emissive regions that, when activated within a device, emit two different colors as previously described.

As used herein, emissive materials, layers, and regions may be distinguished from one another and from other structures based upon light initially generated by the material, layer or region, as opposed to light eventually emitted by the same or a different structure. The initial light generation typically is the result of an energy level change resulting in emission of a photon. For example, an organic emissive material may initially generate blue light, which may be converted by a color filter, quantum dot or other structure to red or green light, such that a complete emissive stack or sub-pixel emits the red or green light. In this case the initial emissive material or layer may be referred to as a "blue" component, even though the sub-pixel is a "red" or "green" component.

In some cases, it may be preferable to describe the color of a component such as an emissive region, sub-pixel, color altering layer, or the like, in terms of 1931 CIE coordinates. For example, a yellow emissive material may have multiple peak emission wavelengths, one in or near an edge of the "green" region, and one within or near an edge of the "red" region as previously described. Accordingly, as used herein, each color term also corresponds to a shape in the 1931 CIE coordinate color space. The shape in 1931 CIE color space is constructed by following the locus between two color points and any additional interior points. For example, interior shape parameters for red, green, blue, and yellow may be defined as shown below:

| **Color** | **CIE Shape Parameters** |
|---|---|
| Central Red | Locus: [0.6270,0.3725];[0.7347,0.2653]; |
| | lnterior:[0.5086,0.2657] |
| Central Green | Locus: [0.0326,0.3530];[0.3731,0.6245]; |
| | Interior: [0.2268,0.3321 |
| Central Blue | Locus: [0.1746,0.0052];[0.0326,0.3530]; |
| | Interior:[0.2268,0.3321] |
| Central Yellow | Locus: [0.373 I,0.6245];[0.6270,0.3725]; |
| | Interior: [0.3 700,0.4087];[0.2886,0.4572] |

More details on OLEDs, and the definitions described above, can be found in US Pat. No. 7,279,704, which is incorporated herein by reference in its entirety.

### SUMMARY

According to an embodiment, an organic light emitting diode/device (OLED) is also provided. The OLED can include an anode, a cathode, and an organic layer, disposed between the anode and the cathode. According to an embodiment, the organic light emitting device is incorporated into one or more device selected from a consumer product, an electronic component module, and/or a lighting panel.

An organic vapor jet printing (OVJP) system/device is provided, which includes one or more OVJP print bars, each including one or more OVJP print heads configured to eject material substantially in a primary vertical direction toward a substrate, each OVJP print head having a plurality of apertures disposed across a horizontal distance *W* on a surface of the print head facing the substrate; and a float table configured to hold the substrate below the one or more OVJP print bars, where the float table is movable through a distance of at least W in each of two horizontal dimensions in a plane perpendicular to the primary vertical direction during operation of the system, or the float table is movable in a first dimension in a plane perpendicular to the primary vertical direction during operation of the system and the one or more OVJP print bars are movable through a distance at least equal to W in a second dimension perpendicular to the first dimension and perpendicular to the primary vertical direction. The OVJP print bars may be fixed in place horizontally and the print heads may be movable through a distance of not more than W in the two horizontal dimensions, and/or the print bars may be movable through a distance of not more than W in the two horizontal dimensions. The float table may be movable through a distance of at least 10*W* in each of the two horizontal dimensions. The float table may be movable through a distance equal to at least twice an edge dimension of the substrate in one of the two horizontal dimensions that is parallel to the direction of motion as the substrate is moved through the OVJP device during deposition of material on the substrate. The float table also may be movable through a distance at least equal to an edge dimension of the substrate in each of the two horizontal dimensions. The float table may include a pressure-vacuum (PV) float table or any other suitable substrate support mechanism. The height of each of the plurality of OVJP print bars may be adjustable, and/or the height of the print heads on each print bar may be adjustable independently of the height of the print bar on which it is positioned. The system may include a total number of OVJP print heads sufficient to deposit material over not more than 50% of the substrate. The total number of print heads may be disposed on a single print bar, or the total number disposed on all print bars may be sufficient to cover not more than 50% of the substrate, or each of multiple OVJP print bars may include a total number of OVJP print heads sufficient to deposit material over not more than 50% of the substrate. The angle of the print heads relative to the substrate and a position of each print head in a dimension perpendicular to the primary direction of motion of the float table may be independently controllable. The device may include one or more sensors arranged and configured to determine a relative position of the substrate below the OVJP print bars and a controller arranged and configured to adjust a position and/or an angle of each of the OVJP print head based on data obtained by the sensor. Each OVJP print head may be integrally connected to and/or in fluid communication with a material source chamber specific to that print head. The print heads may include a cooled particle filter arranged and configured to remove organic material from a flow of material below the one or more OVJP print bars before the flow of material is removed via one or more exhausts. The OVJP print heads may include delivery apertures having a minimum length of 2 mm or more. A manifold hermetically sealed to the print heads may provide source materials to the one or more OVJP print heads. Note that the term organic vapor jet printing (OVJP) system is used herein synonymously with the term organic vapor jet printing (OVJP) device.

### BRIEF DESCRIPTION OF THE DRAWINGS

FIG. 1 shows an organic light emitting device.
FIG. 2 shows an inverted organic light emitting device that does not have a separate electron transport layer.
FIG. 3 shows a conventional OVJP system architecture including a static print head gantry populated with print heads over the entire lateral dimension of the substrate, which is moving in the longitudinal direction on a PV table. Print heads for only one color are shown.
FIG. 4 shows an OVJP system as disclosed herein, which includes static print heads and a PV table configured to move the substrate in X and Y dimensions.
FIG. 5A shows an OVJP system as disclosed herein, in which print heads move in the lateral direction on a static gantry and a PV table is movable in the longitudinal direction.
FIG. 5B shows an OVJP system as disclosed herein, in which print engines move independently on a static gantry and a PV table is movable in the longitudinal direction.
FIG. 6 shows an OVJP system as disclosed herein, in which print heads are movable in the lateral direction on a gantry moving in the longitudinal direction.
FIG. 7A shows a high-level structure of an edge-on OVJP print die assembly as disclosed herein. The length of the nozzles is limited by the thickness of the wafers from which the dies are made. FIG. 7B shows a high-level structure of an in-plane OVJP print die assembly as disclosed herein, in which the OVJP nozzles can be made much longer than in the edge-on case.
FIG. 8 shows an example of a stand-alone configuration station used to align print heads to each other and to the print bar in a conventional OVJP system architecture.
FIG. 9 shows an example of OVJP print heads having individual rotational and lateral position adjustment as disclosed herein.
FIG. 10 shows an example of a moving optical distance-sensor based system to align print heads to each other for OVJP systems as disclosed herein.
FIG. 11 shows an example of system alignment cameras registering the optical distance sensor according to embodiments disclosed herein.
FIG. 12A shows an example of organic gas distribution configurations used with a conventional OVJP system architecture, which requires external, large-volume sources, long supply and exhaust lines, and manifolds with a large number of branches. FIG. 12B shows an example of a distribution configuration according to embodiments disclosed herein, in which print heads or bars use dedicated and/or integrated organic material sources.
FIGS. 13A and 13B show examples of a fixed-gantry system as disclosed herein depositing material on an MMG substrate layout with 2 differently oriented panel types. This example shows a set of landscape-oriented 55" panel and a set of portrait-oriented 65" panel. FIG. 13A shows the trajectory used to print the 55" panel, in which the PV table scans back and forth in the longitudinal direction and steps in the lateral direction. FIG. 13B shows the trajectory for the 65" panel, in which the PV table scans back and forth in the lateral direction and steps in the longitudinal direction.

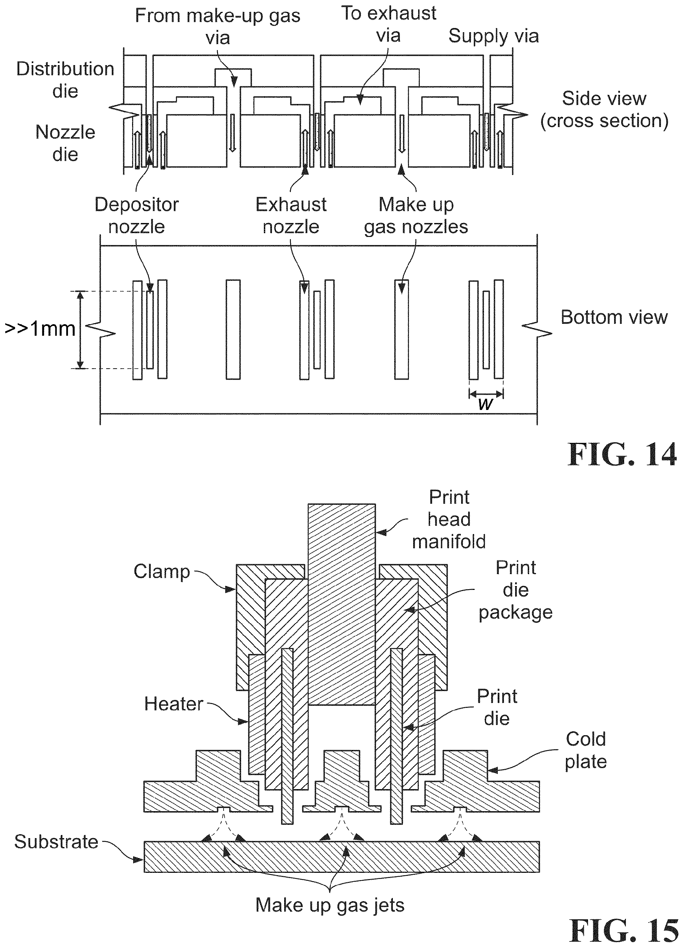

FIG. 14 shows an in-plane die with additional nozzles located between sets of depositor and exhaust apertures corresponding to individual lines according to embodiments disclosed herein. These nozzles supply additional chamber pressure make-up gas to ensure that the confinement effect of the exhaust is uniform across the die in the scan direction. Similar configurations may be used for edge-on dies. FIG. 15 shows additional nozzles (or jets) implemented in the print head cold plate, an actively cooled plate located at the bottom of the print head surrounding the die, used to control the temperature of the substrate during the printing process. The 2 die shown are staggered in the X-direction as shown in FIG. 14 and the die are clamped or bonded to the manifolds.
FIG. 16Ashows an edge on print die integrated in a manifold assembly formed from a manifold block on one side and a heat spreader on the other according to embodiments disclosed herein. FIG. 16B shows an in-plane die attached to a monolithic manifold assembly according to embodiments disclosed herein.

### DETAILED DESCRIPTION

Generally, an OLED comprises at least one organic layer disposed between and electrically connected to an anode and a cathode. When a current is applied, the anode injects holes and the cathode injects electrons into the organic layer(s). The injected holes and electrons each migrate toward the oppositely charged electrode. When an electron and hole localize on the same molecule, an "exciton," which is a localized electron-hole pair having an excited energy state, is formed. Light is emitted when the exciton relaxes via a photoemissive mechanism. In some cases, the exciton may be localized on an excimer or an exciplex. Non-radiative mechanisms, such as thermal relaxation, may also occur, but are generally considered undesirable.

The initial OLEDs used emissive molecules that emitted light from their singlet states ("fluorescence") as disclosed, for example, in U.S. Pat. No. 4,769,292, which is incorporated by reference in its entirety. Fluorescent emission generally occurs in a time frame of less than 10 nanoseconds.

More recently, OLEDs having emissive materials that emit light from triplet states ("phosphorescence") have been demonstrated. Baldo et al., "Highly Efficient Phosphorescent Emission from Organic Electroluminescent Devices," Nature, vol. 395, 151-154, 1998; ("Baldo-I") and Baldo et al., "Very high-efficiency green organic light-emitting devices based on electrophosphorescence," Appl. Phys. Lett., vol. 75, No. 3, 4-6 (1999) ("Baldo-II"), are incorporated by reference in their entireties. Phosphorescence is described in more detail in US Pat. No. 7,279,704 at cols. 5-6, which are incorporated by reference.

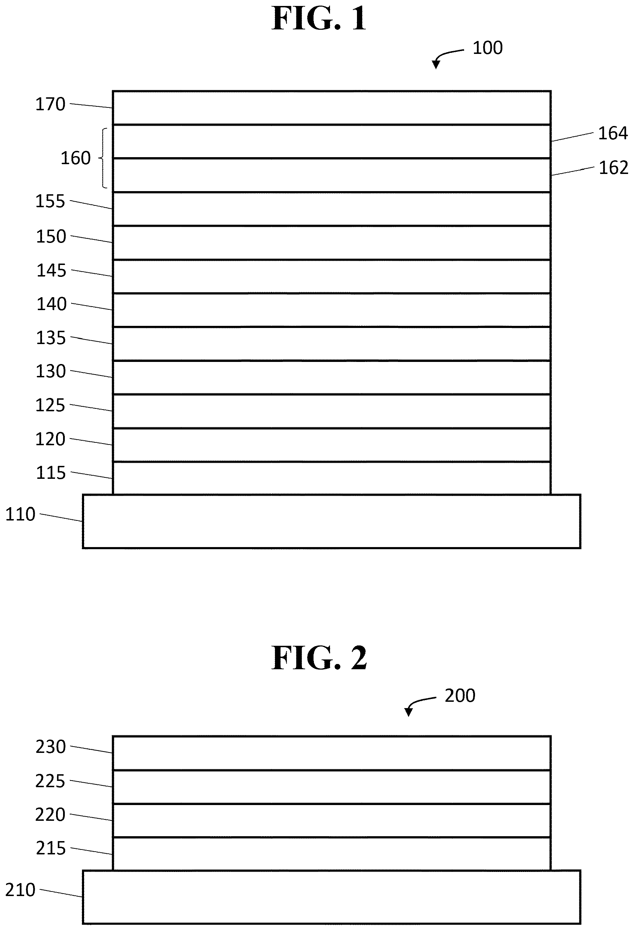

FIG. 1 shows an organic light emitting device 100. The figures are not necessarily drawn to scale. Device 100 may include a substrate 110, an anode 115, a hole injection layer 120, a hole transport layer 125, an electron blocking layer 130, an emissive layer 135, a hole blocking layer 140, an electron transport layer 145, an electron injection layer 150, a protective layer 155, a cathode 160, and a barrier layer 170. Cathode 160 is a compound cathode having a first conductive layer 162 and a second conductive layer 164. Device 100 may be fabricated by depositing the layers described, in order. The properties and functions of these various layers, as well as example materials, are described in more detail in US 7,279,704 at cols. 6-10, which are incorporated by reference.

More examples for each of these layers are available. For example, a flexible and transparent substrate-anode combination is disclosed in U.S. Pat. No. 5,844,363, which is incorporated by reference in its entirety. An example of a p-doped hole transport layer is m-MTDATA doped with F₄-TCNQ at a molar ratio of 50:1, as disclosed in U.S. Patent Application Publication No. 2003/0230980, which is incorporated by reference in its entirety. Examples of emissive and host materials are disclosed in U.S. Pat. No. 6,303,238 to Thompson et al., which is incorporated by reference in its entirety. An example of an n-doped electron transport layer is BPhen doped with Li at a molar ratio of 1:1, as disclosed in U.S. Patent Application Publication No. 2003/0230980, which is incorporated by reference in its entirety. U.S. Pat. Nos. 5,703,436 and 5,707,745, which are incorporated by reference in their entireties, disclose examples of cathodes including compound cathodes having a thin layer of metal such as Mg:Ag with an overlying transparent, electrically-conductive, sputter-deposited ITO layer. The theory and use of blocking layers is described in more detail in U.S. Pat. No. 6,097,147 and U.S. Patent Application Publication No. 2003/0230980, which are incorporated by reference in their entireties. Examples of injection layers are provided in U.S. Patent Application Publication No. 2004/0174116, which is incorporated by reference in its entirety. Barrier layer 170 may be a single- or multi-layer barrier and may cover or surround the other layers of the device. The barrier layer 170 may also surround the substrate 110, and/or it may be arranged between the substrate and the other layers of the device. The barrier also may be referred to as an encapsulant, encapsulation layer, protective layer, or permeation barrier, and typically provides protection against permeation by moisture, ambient air, and other similar materials through to the other layers of the device. Examples of barrier layer materials and structures are provided in U.S. Patent Nos. 6,537,688, 6,597,111, 6,664,137, 6,835,950, 6,888,305, 6,888,307, 6,897,474, 7,187,119, and 7,683,534, each of which is incorporated by reference in its entirety.

FIG. 2 shows an inverted OLED 200. The device includes a substrate 210, a cathode 215, an emissive layer 220, a hole transport layer 225, and an anode 230. Device 200 may be fabricated by depositing the layers described, in order. Because the most common OLED configuration has a cathode disposed over the anode, and device 200 has cathode 215 disposed under anode 230, device 200 may be referred to as an "inverted" OLED. Materials similar to those described with respect to device 100 may be used in the corresponding layers of device 200. FIG. 2 provides one example of how some layers may be omitted from the structure of device 100.

The simple layered structure illustrated in FIGS. 1 and 2 is provided by way of non-limiting example, and it is understood that embodiments of the invention may be used in connection with a wide variety of other structures. The specific materials and structures described are exemplary in nature, and other materials and structures may be used. Functional OLEDs may be achieved by combining the various layers described in different ways, or layers may be omitted entirely, based on design, performance, and cost factors. Other layers not specifically described may also be included. Materials other than those specifically described may be used. Although many of the examples provided herein describe various layers as comprising a single material, it is understood that combinations of materials, such as a mixture of host and dopant, or more generally a mixture, may be used. Also, the layers may have various sublayers. The names given to the various layers herein are not intended to be strictly limiting. For example, in device 200, hole transport layer 225 transports holes and injects holes into emissive layer 220, and may be described as a hole transport layer or a hole injection layer. In one embodiment, an OLED may be described as having an "organic layer" disposed between a cathode and an anode. This organic layer may comprise a single layer, or may further comprise multiple layers of different organic materials as described, for example, with respect to FIGS. 1 and 2.

Structures and materials not specifically described may also be used, such as OLEDs comprised of polymeric materials (PLEDs) such as disclosed in U.S. Pat. No. 5,247,190 to Friend et al., which is incorporated by reference in its entirety. By way of further example, OLEDs having a single organic layer may be used. OLEDs may be stacked, for example as described in U.S. Pat. No. 5,707,745 to Forrest et al, which is incorporated by reference in its entirety. The OLED structure may deviate from the simple layered structure illustrated in FIGS. 1 and 2. For example, the substrate may include an angled reflective surface to improve out-coupling, such as a mesa structure as described in U.S. Pat. No. 6,091,195 to Forrest et al., and/or a pit structure as described in U.S. Pat. No. 5,834,893 to Bulovic et al., which are incorporated by reference in their entireties.

In some embodiments disclosed herein, emissive layers or materials, such as emissive layer 135 and emissive layer 220 shown in FIGS. 1-2, respectively, may include quantum dots. An "emissive layer" or "emissive material" as disclosed herein may include an organic emissive material and/or an emissive material that contains quantum dots or equivalent structures, unless indicated to the contrary explicitly or by context according to the understanding of one of skill in the art. In general, an emissive layer includes emissive material within a host matrix. Such an emissive layer may include only a quantum dot material which converts light emitted by a separate emissive material or other emitter, or it may also include the separate emissive material or other emitter, or it may emit light itself directly from the application of an electric current. Similarly, a color altering layer, color filter, upconversion, or downconversion layer or structure may include a material containing quantum dots, though such layer may not be considered an "emissive layer" as disclosed herein. In general, an "emissive layer" or material is one that emits an initial light based on an injected electrical charge, where the initial light may be altered by another layer such as a color filter or other color altering layer that does not itself emit an initial light within the device, but may re-emit altered light of a different spectra content based upon absorption of the initial light emitted by the emissive layer and downconversion to a lower energy light emission. In some embodiments disclosed herein, the color altering layer, color filter, upconversion, and/or downconversion layer may be disposed outside of an OLED device, such as above or below an electrode of the OLED device.

Unless otherwise specified, any of the layers of the various embodiments may be deposited by any suitable method. For the organic layers, preferred methods include thermal evaporation, ink-jet, such as described in U.S. Pat. Nos. 6,013,982 and 6,087,196, which are incorporated by reference in their entireties, organic vapor phase deposition (OVPD), such as described in U.S. Pat. No. 6,337,102 to Forrest et al., which is incorporated by reference in its entirety, and deposition by organic vapor jet printing (OVJP), such as described in U.S. Pat. No. 7,431,968, which is incorporated by reference in its entirety. Other suitable deposition methods include spin coating and other solution based processes. Solution based processes are preferably carried out in nitrogen or an inert atmosphere. For the other layers, preferred methods include thermal evaporation. Preferred patterning methods include deposition through a mask, cold welding such as described in U.S. Pat. Nos. 6,294,398 and 6,468,819, which are incorporated by reference in their entireties, and patterning associated with some of the deposition methods such as ink-jet and OVJD. Other methods may also be used. The materials to be deposited may be modified to make them compatible with a particular deposition method. For example, substituents such as alkyl and aryl groups, branched or unbranched, and preferably containing at least 3 carbons, may be used in small molecules to enhance their ability to undergo solution processing. Substituents having 20 carbons or more may be used, and 3-20 carbons is a preferred range. Materials with asymmetric structures may have better solution processibility than those having symmetric structures, because asymmetric materials may have a lower tendency to recrystallize. Dendrimer substituents may be used to enhance the ability of small molecules to undergo solution processing.

Devices fabricated in accordance with embodiments of the present invention may further optionally comprise a barrier layer. One purpose of the barrier layer is to protect the electrodes and organic layers from damaging exposure to harmful species in the environment including moisture, vapor and/or gases, etc. The barrier layer may be deposited over, under or next to a substrate, an electrode, or over any other parts of a device including an edge. The barrier layer may comprise a single layer, or multiple layers. The barrier layer may be formed by various known chemical vapor deposition techniques and may include compositions having a single phase as well as compositions having multiple phases. Any suitable material or combination of materials may be used for the barrier layer. The barrier layer may incorporate an inorganic or an organic compound or both. The preferred barrier layer comprises a mixture of a polymeric material and a non-polymeric material as described in U.S. Pat. No. 7,968,146, PCT Pat. Application Nos. PCT/US2007/023098 and PCT/US2009/042829, which are herein incorporated by reference in their entireties. To be considered a "mixture", the aforesaid polymeric and non-polymeric materials comprising the barrier layer should be deposited under the same reaction conditions and/or at the same time. The weight ratio of polymeric to non-polymeric material may be in the range of 95:5 to 5:95. The polymeric material and the non-polymeric material may be created from the same precursor material. In one example, the mixture of a polymeric material and a non-polymeric material consists essentially of polymeric silicon and inorganic silicon.

In some embodiments, at least one of the anode, the cathode, or a new layer disposed over the organic emissive layer functions as an enhancement layer. The enhancement layer comprises a plasmonic material exhibiting surface plasmon resonance that non-radiatively couples to the emitter material and transfers excited state energy from the emitter material to non-radiative mode of surface plasmon polariton. The enhancement layer is provided no more than a threshold distance away from the organic emissive layer, wherein the emitter material has a total non-radiative decay rate constant and a total radiative decay rate constant due to the presence of the enhancement layer and the threshold distance is where the total non-radiative decay rate constant is equal to the total radiative decay rate constant. In some embodiments, the OLED further comprises an outcoupling layer. In some embodiments, the outcoupling layer is disposed over the enhancement layer on the opposite side of the organic emissive layer. In some embodiments, the outcoupling layer is disposed on opposite side of the emissive layer from the enhancement layer but still outcouples energy from the surface plasmon mode of the enhancement layer. The outcoupling layer scatters the energy from the surface plasmon polaritons. In some embodiments this energy is scattered as photons to free space. In other embodiments, the energy is scattered from the surface plasmon mode into other modes of the device such as but not limited to the organic waveguide mode, the substrate mode, or another waveguiding mode. If energy is scattered to the non-free space mode of the OLED other outcoupling schemes could be incorporated to extract that energy to free space. In some embodiments, one or more intervening layer can be disposed between the enhancement layer and the outcoupling layer. The examples for interventing layer(s) can be dielectric materials, including organic, inorganic, perovskites, oxides, and may include stacks and/or mixtures of these materials.

The enhancement layer modifies the effective properties of the medium in which the emitter material resides resulting in any or all of the following: a decreased rate of emission, a modification of emission line-shape, a change in emission intensity with angle, a change in the stability of the emitter material, a change in the efficiency of the OLED, and reduced efficiency roll-off of the OLED device. Placement of the enhancement layer on the cathode side, anode side, or on both sides results in OLED devices which take advantage of any of the above-mentioned effects. In addition to the specific functional layers mentioned herein and illustrated in the various OLED examples shown in the figures, the OLEDs according to the present disclosure may include any of the other functional layers often found in OLEDs.

The enhancement layer can be comprised of plasmonic materials, optically active metamaterials, or hyperbolic metamaterials. As used herein, a plasmonic material is a material in which the real part of the dielectric constant crosses zero in the visible or ultraviolet region of the electromagnetic spectrum. In some embodiments, the plasmonic material includes at least one metal. In such embodiments the metal may include at least one of Ag, Al, Au, Ir, Pt, Ni, Cu, W, Ta, Fe, Cr, Mg, Ga, Rh, Ti, Ru, Pd, In, Bi, Ca alloys or mixtures of these materials, and stacks of these materials. In general, a metamaterial is a medium composed of different materials where the medium as a whole acts differently than the sum of its material parts. In particular, we define optically active metamaterials as materials which have both negative permittivity and negative permeability. Hyperbolic metamaterials, on the other hand, are anisotropic media in which the permittivity or permeability are of different sign for different spatial directions. Optically active metamaterials and hyperbolic metamaterials are strictly distinguished from many other photonic structures such as Distributed Bragg Reflectors ("DBRs") in that the medium should appear uniform in the direction of propagation on the length scale of the wavelength of light. Using terminology that one skilled in the art can understand: the dielectric constant of the metamaterials in the direction of propagation can be described with the effective medium approximation. Plasmonic materials and metamaterials provide methods for controlling the propagation of light that can enhance OLED performance in a number of ways.

In some embodiments, the enhancement layer is provided as a planar layer. In other embodiments, the enhancement layer has wavelength-sized features that are arranged periodically, quasi-periodically, or randomly, or sub-wavelength-sized features that are arranged periodically, quasi-periodically, or randomly. In some embodiments, the wavelength-sized features and the sub-wavelength-sized features have sharp edges.

In some embodiments, the outcoupling layer has wavelength-sized features that are arranged periodically, quasi-periodically, or randomly, or sub-wavelength-sized features that are arranged periodically, quasi-periodically, or randomly. In some embodiments, the outcoupling layer may be composed of a plurality of nanoparticles and in other embodiments the outcoupling layer is composed of a pluraility of nanoparticles disposed over a material. In these embodiments the outcoupling may be tunable by at least one of varying a size of the plurality of nanoparticles, varying a shape of the plurality of nanoparticles, changing a material of the plurality of nanoparticles, adjusting a thickness of the material, changing the refractive index of the material or an additional layer disposed on the plurality of nanoparticles, varying a thickness of the enhancement layer, and/or varying the material of the enhancement layer. The plurality of nanoparticles of the device may be formed from at least one of metal, dielectric material, semiconductor materials, an alloy of metal, a mixture of dielectric materials, a stack or layering of one or more materials, and/or a core of one type of material and that is coated with a shell of a different type of material. In some embodiments, the outcoupling layer is composed of at least metal nanoparticles wherein the metal is selected from the group consisting of Ag, Al, Au, Ir, Pt, Ni, Cu, W, Ta, Fe, Cr, Mg, Ga, Rh, Ti, Ru, Pd, In, Bi, Ca, alloys or mixtures of these materials, and stacks of these materials. The plurality of nanoparticles may have additional layer disposed over them. In some embodiments, the polarization of the emission can be tuned using the outcoupling layer. Varying the dimensionality and periodicity of the outcoupling layer can select a type of polarization that is preferentially outcoupled to air. In some embodiments the outcoupling layer also acts as an electrode of the device.

It is believed that the internal quantum efficiency (IQE) of fluorescent OLEDs can exceed the 25% spin statistics limit through delayed fluorescence. As used herein, there are two types of delayed fluorescence, i.e. P-type delayed fluorescence and E-type delayed fluorescence. P-type delayed fluorescence is generated from triplet-triplet annihilation (TTA).

On the other hand, E-type delayed fluorescence does not rely on the collision of two triplets, but rather on the thermal population between the triplet states and the singlet excited states. Compounds that are capable of generating E-type delayed fluorescence are required to have very small singlet-triplet gaps. Thermal energy can activate the transition from the triplet state back to the singlet state. This type of delayed fluorescence is also known as thermally activated delayed fluorescence (TADF). A distinctive feature of TADF is that the delayed component increases as temperature rises due to the increased thermal energy. If the reverse intersystem crossing rate is fast enough to minimize the non-radiative decay from the triplet state, the fraction of back populated singlet excited states can potentially reach 75%. The total singlet fraction can be 100%, far exceeding the spin statistics limit for electrically generated excitons.

E-type delayed fluorescence characteristics can be found in an exciplex system or in a single compound. Without being bound by theory, it is believed that E-type delayed fluorescence requires the luminescent material to have a small singlet-triplet energy gap (ΔES-T). Organic, non-metal containing, donor-acceptor luminescent materials may be able to achieve this. The emission in these materials is often characterized as a donor-acceptor charge-transfer (CT) type emission. The spatial separation of the HOMO and LUMO in these donor-acceptor type compounds often results in small ΔES-T. These states may involve CT states. Often, donor-acceptor luminescent materials are constructed by connecting an electron donor moiety such as amino- or carbazole-derivatives and an electron acceptor moiety such as N-containing six-membered aromatic ring.

Devices fabricated in accordance with embodiments of the invention can be incorporated into a wide variety of electronic component modules (or units) that can be incorporated into a variety of electronic products or intermediate components. Examples of such electronic products or intermediate components include display screens, lighting devices such as discrete light source devices or lighting panels, etc. that can be utilized by the end-user product manufacturers. Such electronic component modules can optionally include the driving electronics and/or power source(s). Devices fabricated in accordance with embodiments of the invention can be incorporated into a wide variety of consumer products that have one or more of the electronic component modules (or units) incorporated therein. A consumer product comprising an OLED that includes the compound of the present disclosure in the organic layer in the OLED is disclosed. Such consumer products would include any kind of products that include one or more light source(s) and/or one or more of some type of visual displays. Some examples of such consumer products include a flat panel display, a curved display, a computer monitor, a medical monitor, a television, a billboard, a light for interior or exterior illumination and/or signaling, a heads-up display, a fully or partially transparent display, a flexible display, a rollable display, a foldable display, a stretchable display, a laser printer, a telephone, a cell phone, tablet, a phablet, a personal digital assistant (PDA), a wearable device, a laptop computer, a digital camera, a camcorder, a viewfinder, a micro-display that is less than 2 inches diagonal, a 3-D display, a virtual reality or augmented reality display, a vehicle, a video walls comprising multiple displays tiled together, a theater or stadium screen, and a sign. Various control mechanisms may be used to control devices fabricated in accordance with the present invention, including passive matrix and active matrix. Many of the devices are intended for use in a temperature range comfortable to humans, such as 18 C to 30 C, and more preferably at room temperature (20-25 C), but could be used outside this temperature range, for example, from - 40 C to 80 C.

The materials and structures described herein may have applications in devices other than OLEDs. For example, other optoelectronic devices such as organic solar cells and organic photodetectors may employ the materials and structures. More generally, organic devices, such as organic transistors, may employ the materials and structures.

In some embodiments, the OLED has one or more characteristics selected from the group consisting of being flexible, being rollable, being foldable, being stretchable, and being curved. In some embodiments, the OLED is transparent or semi-transparent. In some embodiments, the OLED further comprises a layer comprising carbon nanotubes.

In some embodiments, the OLED further comprises a layer comprising a delayed fluorescent emitter. In some embodiments, the OLED comprises a RGB pixel arrangement or white plus color filter pixel arrangement. In some embodiments, the OLED is a mobile device, a hand held device, or a wearable device. In some embodiments, the OLED is a display panel having less than 10 inch diagonal or 50 square inch area. In some embodiments, the OLED is a display panel having at least 10 inch diagonal or 50 square inch area. In some embodiments, the OLED is a lighting panel.

In some embodiments of the emissive region, the emissive region further comprises a host.

In some embodiments, the compound can be an emissive dopant. In some embodiments, the compound can produce emissions via phosphorescence, fluorescence, thermally activated delayed fluorescence, i.e., TADF (also referred to as E-type delayed fluorescence), triplet-triplet annihilation, or combinations of these processes.

The OLED disclosed herein can be incorporated into one or more of a consumer product, an electronic component module, and a lighting panel. The organic layer can be an emissive layer and the compound can be an emissive dopant in some embodiments, while the compound can be a non-emissive dopant in other embodiments.

The organic layer can also include a host. In some embodiments, two or more hosts are preferred. In some embodiments, the hosts used maybe a) bipolar, b) electron transporting, c) hole transporting or d) wide band gap materials that play little role in charge transport. In some embodiments, the host can include a metal complex. The host can be an inorganic compound.

### COMBINATION WITH OTHER MATERIALS

The materials described herein as useful for a particular layer in an organic light emitting device may be used in combination with a wide variety of other materials present in the device. For example, emissive dopants disclosed herein may be used in conjunction with a wide variety of hosts, transport layers, blocking layers, injection layers, electrodes and other layers that may be present. The materials described or referred to below are non-limiting examples of materials that may be useful in combination with the compounds disclosed herein, and one of skill in the art can readily consult the literature to identify other materials that may be useful in combination.

Various materials may be used for the various emissive and non-emissive layers and arrangements disclosed herein. Examples of suitable materials are disclosed in U.S. Patent Application Publication No. 2017/0229663, which is incorporated by reference in its entirety.

### Conductivity Dopants:

A charge transport layer can be doped with conductivity dopants to substantially alter its density of charge carriers, which will in turn alter its conductivity. The conductivity is increased by generating charge carriers in the matrix material, and depending on the type of dopant, a change in the Fermi level of the semiconductor may also be achieved. Hole-transporting layer can be doped by p-type conductivity dopants and n-type conductivity dopants are used in the electron-transporting layer.

### HIL/HTL:

A hole injecting/transporting material to be used in the present invention is not particularly limited, and any compound may be used as long as the compound is typically used as a hole injecting/transporting material.

### EBL:

An electron blocking layer (EBL) may be used to reduce the number of electrons and/or excitons that leave the emissive layer. The presence of such a blocking layer in a device may result in substantially higher efficiencies, and or longer lifetime, as compared to a similar device lacking a blocking layer. Also, a blocking layer may be used to confine emission to a desired region of an OLED. In some embodiments, the EBL material has a higher LUMO (closer to the vacuum level) and/or higher triplet energy than the emitter closest to the EBL interface. In some embodiments, the EBL material has a higher LUMO (closer to the vacuum level) and or higher triplet energy than one or more of the hosts closest to the EBL interface. In one aspect, the compound used in EBL contains the same molecule or the same functional groups used as one of the hosts described below.

### Host:

The light emitting layer of the organic EL device of the present invention preferably contains at least a metal complex as light emitting material, and may contain a host material using the metal complex as a dopant material. Examples of the host material are not particularly limited, and any metal complexes or organic compounds may be used as long as the triplet energy of the host is larger than that of the dopant. Any host material may be used with any dopant so long as the triplet criteria is satisfied.

### HBL:

A hole blocking layer (HBL) may be used to reduce the number of holes and/or excitons that leave the emissive layer. The presence of such a blocking layer in a device may result in substantially higher efficiencies and/or longer lifetime as compared to a similar device lacking a blocking layer. Also, a blocking layer may be used to confine emission to a desired region of an OLED. In some embodiments, the HBL material has a lower HOMO (further from the vacuum level) and or higher triplet energy than the emitter closest to the HBL interface. In some embodiments, the HBL material has a lower HOMO (further from the vacuum level) and or higher triplet energy than one or more of the hosts closest to the HBL interface.

### ETL:

An electron transport layer (ETL) may include a material capable of transporting electrons. The electron transport layer may be intrinsic (undoped), or doped. Doping may be used to enhance conductivity. Examples of the ETL material are not particularly limited, and any metal complexes or organic compounds may be used as long as they are typically used to transport electrons.

### Charge generation layer (CGL)

In tandem or stacked OLEDs, the CGL plays an essential role in the performance, which is composed of an n-doped layer and a p-doped layer for injection of electrons and holes, respectively. Electrons and holes are supplied from the CGL and electrodes. The consumed electrons and holes in the CGL are refilled by the electrons and holes injected from the cathode and anode, respectively; then, the bipolar currents reach a steady state gradually. Typical CGL materials include n and p conductivity dopants used in the transport layers.

Conventional systems and techniques used to fabricate OLED devices such as display panels may be inefficient and overly complex for some applications, such as large panel active-matrix TVs. Embodiments disclosed herein provide systems and techniques that may reduce system complexity and improve reliability and lateral position accuracy of the OVJP deposition system, as well as facilitating and enabling processing of multiple TV models, display panel sizes, or the like, whether on separate substrates or a single substrate, such as in multi-model glass (MMG) arrangements.

As previously disclosed, OVJP processes suitable for fabrication of OLED panels and similar devices involve the dispensation of OLED material in a heated gaseous mixture through print nozzles, commonly defined in Si dies, onto a receptor substrate. The substrate typically is glass, but may be or include metals, plastics, or combinations thereof, or other materials. The substrate may include pre-existing structures such as a passive or active-matrix display backplane. The heated gas mixture is generally obtained by flowing a carrier gas such as H2, He, N2 or Ar, through a sublimation/evaporation source containing the OLED material. OVJP differs from other deposition techniques such as vapor phase deposition, vacuum thermal evaporation (VTE), atomic layer deposition (ALD), and others, and typically deposition systems known for those techniques are not suitable for, and cannot be readily adapted for OVJP techniques and materials. For example, ALD requires at least two separate precursors, each of which forms a self-limiting monolayer on the substrate surface. The precursors are delivered alternately to the substrate, forming one atomic layer on the surface after exposures to pairs of the precursors. In contrast, OVJP is a condensation process where the gaseous organic materials condense on the relatively cooler substrate. As another example, OVJP uses relatively high temperatures for sublimating/evaporating and transporting the organic material to be deposited on a substrate, but uses a relatively cool substrate so as to prevent damage to the organic materials deposited on the substrate. Temperatures for OVJP organic sublimation sources typically range from 200 C to 450 C, which is a much higher range than is used for chemical vapor deposition (CVD) and similar techniques. CVD also uses a substrate temperature significantly higher than the temperature of the source material to cause the required chemical reaction to occur on the substrate surface. OVJP also uses a very small nozzle width in the OVJP depositors and a relatively very small nozzle-to-substrate separation, both of which contribute to the precision deposition profiles achievable through OVJP which typically cannot be achieved with other spray- or nozzle-based deposition techniques. Further, in contrast to blanket layer deposition techniques, OVJP allows for very precise deposition of materials and generally is not used for large-scale blanket depositions. The OVJP process typically uses pressures between 10 Torr and 1 Atm

(760 Torr) and typically is performed inside a vacuum chamber. The material sources may be arranged within the vacuum chamber or externally.

An OVJP system includes one or more OVJP print heads that convey hot gases containing the organic materials to be deposited on the substrate to discrete locations (for example, pixel or sub-pixel regions) on the substrate via one or more nozzles incorporated in the heads. The substrate typically includes preexisting structures such as passive or active-matrix backplane components. As shown and described herein, OVJP systems typically include a number of OVJP print nozzles, which typically are arranged in a pattern that matches that of the display backplane. In practice, this implies that the nozzle arrangement has the same pitch as the pixels on the resulting display. The nozzles may be provided by, for example, a series of channels through a print die, each of which ends in an aperture from which material is ejected during operation. A "print die" as described herein refers to the component, which includes the deposition and exhaust channels that end in apertures defining the nozzles. The print die typically is fabricated using MEMS processes, though other techniques such as additive manufacturing, laser drilling or ablation, or the like may be used. The nozzles are integrated into assemblies called "print heads," which include gas distribution to the die and manifold from the source, a flight control mechanism that maintains the print dies at a constant gap with respect to the substrate as they move relative to one another and, in some embodiments, component cooling. An OVJP print head may include one or more print dies. The OVJP print head also may include a print manifold to distribute material to the various channels in the print die and ultimately to the nozzles on the bottom (i.e., substrate-facing) side of the print die and the print head. The print manifold typically is a block of material such as metal or silicon to which the print die is attached. The manifold also may connect the print die to the print head assembly. An OVJP print engine typically includes the print die, gas delivery manifold and associated gas lines, the z-positioning or fly height adjustment system and, in some cases, material sublimation sources, such as sources used to generate OLED materials to be deposited on a substrate. Some arrangements disclosed herein use integrated sublimation sources as described in further detail below. Similarly, a "print bar" may include multiple print heads or print engines. During operation, embodiments disclosed herein may allow for independent adjustment of the positioning of individual print bars, print engines, and/or print heads, as described and shown in the various embodiments. Generally, unless not possible based on the specific arrangement, when arrangements disclosed herein refer to arrangement or movement of a print head, the same arrangement may be used with a print engine having additional components in a single controllable unit with the print head.

In OVJP systems, it generally is desirable for the heated gas and organic material mixture to be hermetically conveyed and distributed from and to system gas lines connected to the organic vapor sources and the exhaust assembly, respectively. Accordingly, the print manifold in each print head may be used to route the gas from inlet to print die and from print die to outlet. It is also desirable to maintain the gas temperature within an appropriate range to prevent condensation (at lower temperatures) or decomposition (at higher temperatures), as well as shielding sensitive system components and the substrate from the heat developed in the print head manifold.

It is also desirable to maintain the print dies within a vertical distance of the substrate ("fly height") that corresponds to desired process conditions. OVJP fly heights typically are in the range of 20-60 µm. In some arrangements, a closed-loop system using distance sensors and vertical actuators on each print head may be used to maintain a desired fly height above the substrate.

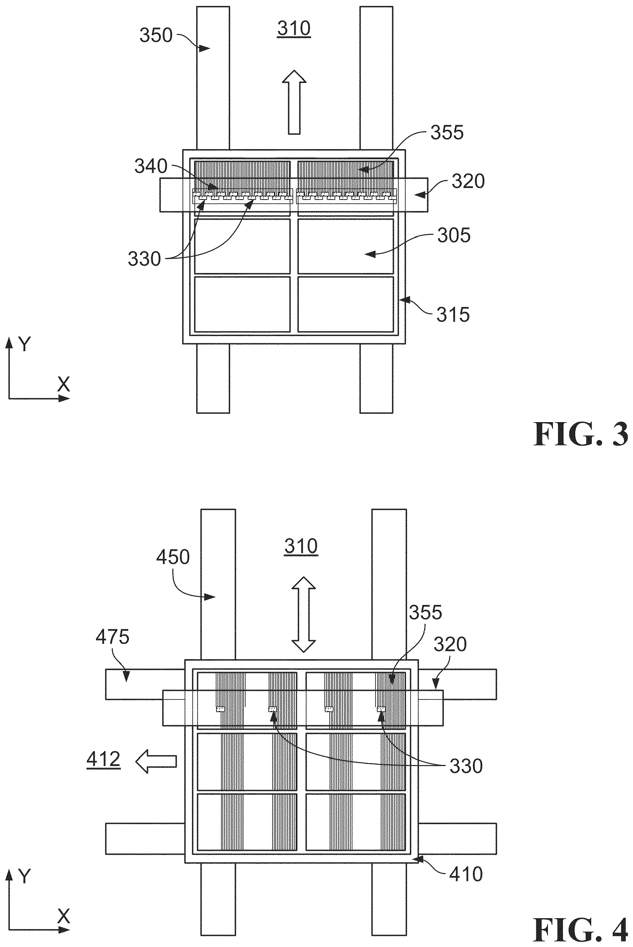

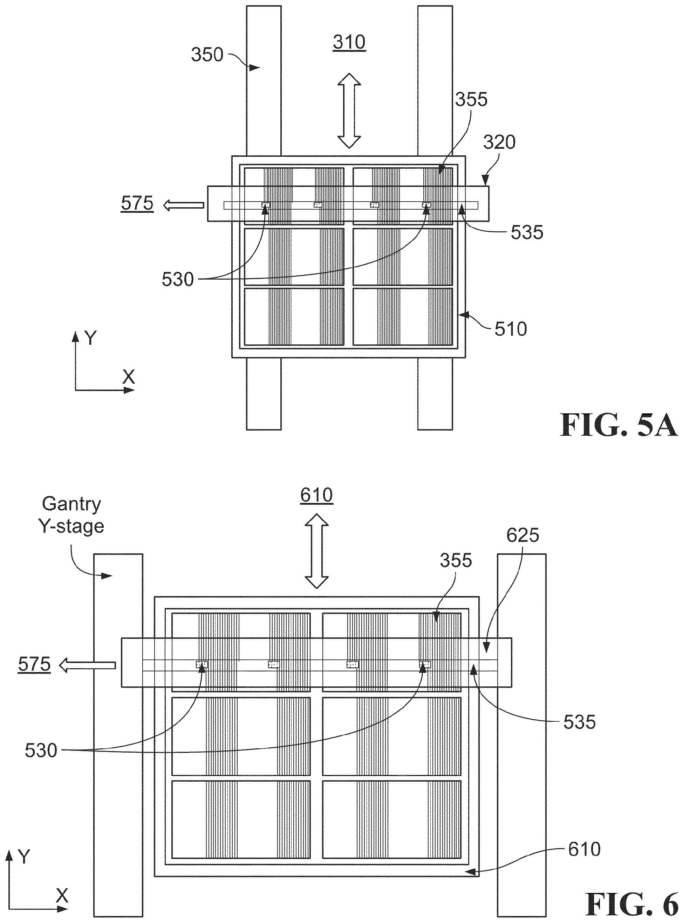

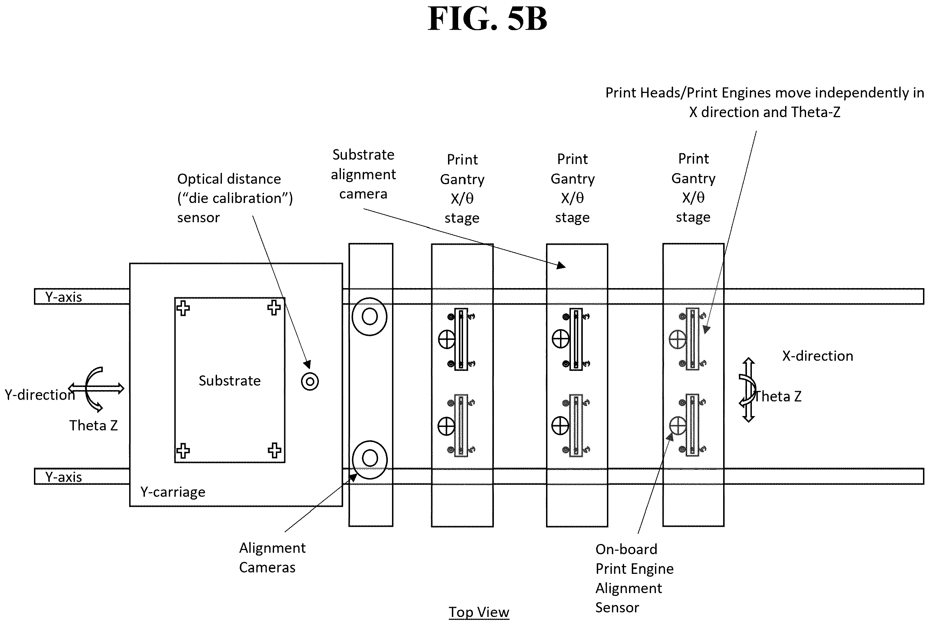

Examples of suitable print die arrangements, fabrication techniques, and the like, are provided in U.S. Patent Nos. 9,583,707, 10,704,144, 11,104,988, 11,220,737, 11,267,012, and 11,588,140, the contents of each of which is incorporated by reference in its entirety, and U.S. Patent Publication No. 2021/0280785, the contents of which is incorporated by reference in its entirety. Illustrative examples of print die arrangements that may be particularly suited for use with the embodiments disclosed herein are described in and shown in FIG. 4 and associated text in U.S. Patent No. 11,267,012, and Figures 5-6 and associated text in U.S. Patent No. 10,704,144, though other arrangements may be used. For example, FIG. 4 of U.S. Patent No. 11,267,012 shows a cross sectional view of a nozzle assembly 400 having delivery channel adjacent to, or surrounded by, one or more exhaust channels 402. Delivery gas transporting material to be deposited is ejected from an aperture of the delivery channel 401. Material 305 that does not deposit on the substrate is removed through the exhaust channel 402. A confinement gas 403 may be provided in a direction opposing the flow of material ejected from the aperture of the delivery channel of the nozzle from a source, such as a nozzle, an ambient source, or the like, from a location below the nozzle and adjacent to the nozzle and/or the exhaust channel 402. The confinement gas may flow inward from the outside of the deposition zone and guide surplus material into the exhaust channels 402. The exhaust channel 402 typically is connected to a vacuum source. The exhaust channel 402 may be angled relative to the delivery channel 401 to improve the uniformity of the deposited material on the substrate, in the defined areas where material is deposited. The exhaust channel 402 may partially or fully surround the the delivery channel 401. In some configurations, the nozzle aperture may be defined by the planar edge of the nozzle block and a channel within the nozzle block, such that an additional tapered or extended physical portion beyond a lower surface of the nozzle block is not required. The nozzle aperture can be bifurcated or otherwise divided, for example by a delivery channel separator 404. As another example, FIGS. 5-6 of U.S. Patent No. 10,704,144 show views of a "DEC" type print die ("nozzle block") that uses one or more shield gas flows around micronozzle arrays. Ambient gas in the OVJP deposition chamber typically is relatively stagnant. A flowing shield gas may use purified so that water and O₂ levels in the deposition chamber are less than 0.001 ppm. In this arrangement, shield gas channels 501 mounted in front of and/or behind the depositing nozzle generate a purified gas flow that isolates the nozzle arrays from residual gasses that may be present in the chamber. Shield gas channels 502 that are mounted between nozzle arrays provide a source for the confinement gas to achieve accurate patterning and prevent vapors from adjacent arrays from bleeding together. FIG.6 of U.S. Patent No. 10,704,144 shows a view of the print die from the substrate-normal direction in FIG. 6. The depositor contains a single aperture or multiple apertures at the terminus of channels inside a monolithic nozzle block. The delivery aperture 603 delivers a mixture of one or more organic vapors entrained within an inert delivery gas. The exhaust aperture 604 is in communication with exhaust channels that withdraw gas from the region between the depositor and substrate. Optional confinement channels 605 are formed by depressions in the depositor face. These channels provide low resistance paths for confinement gas to flow from the edge of the nozzle block towards the midline of the depositor where it is needed to block the spread of organic vapor. Confinement flow in this arrangement is supplied by the gas ambient surrounding the depositor, which is from the shield gas flow as opposed to the chamber ambient. Alternatively, a confinement gas may be supplied via one or more confinement apertures 606.

FIG. 3 shows an OVJP system architecture, which includes a moving pressure-vacuum (PV) table 315 which holds a substrate 305. The view in FIG. 3 is from above the deposition system, i.e., looking down on the print heads 330 with the substrate 305 and PV table 315 disposed below (on the far side of) the print heads 330 from this view. A static gantry 320 holds OVJP print heads 330 arranged on a common print bar 340. The substrate 305 and/or the PV table 315 may be moved under the print heads 330 via a Y-stage track 350 or similar arrangement in the Y direction 310. For example, the substrate may be moved to a first position under the print heads 330 to begin deposition, and moved in the Y direction while the print heads 330 deposit material on the substrate to form a series of printed lines 355. In this configuration, the print heads 330 move only in the vertical direction, i.e., toward and away from the substrate 305, for flight control and deposition start and stop. As a result, the entire width of the substrate 305 measured perpendicular to the direction of motion 300 must be covered by print heads 330, requiring a relatively large number of print heads.

The print die typically has a width of around 30-100 mm, with OVJP nozzles typically extending up to 75% of the length, which is relatively limited in relation to the sizes of the substrate used in display fabrication, as well as the fact that different heads are used for subpixels of different colors (e.g., red, green, and blue subpixels in an RGB arrangement), such an architecture typically requires a large number of print heads. For example, to deposit on a 55-inch diagonal, Gen8.5 display panel, a typical OVJP system would use at least 96 print heads, with an equal number of dies and flight control mechanisms. Each flight control mechanism in turn typically includes at least 2 gap sensors and associated vertical actuators for each flight control mechanism. Controlling the fly height of such a high number of print heads may be particularly complex and, accordingly, ensuring system reliability may be challenging due to the number of components. In addition, since conventional OVJP print heads typically are not movable laterally relative to the substrate, they need to very accurately align to one other at the print bar level prior to integration into the system. This requires a separate alignment assembly that includes a precision position measurement capability moving on a high precision stage, as well as high precision adjustment features for each head.

Furthermore, this style OVJP architecture is essentially dedicated to a specific panel/substrate size or relatively small range of sizes, limiting the types and sizes of display panels that can be manufactured. Changing from one display size to another (whether on different substrates or a common substrate in an MMG layout) typically requires exchanging all the print heads because different display sizes have different pixel pitches, and the print head spacing is chosen to match the display pitch. In practice this can be done by swapping entire print bars that are pre-configured on the alignment assembly. However, such a change typically requires significant system downtime to bring print head temperatures down, vent the deposition chamber, install and align the new print bar(s), reduce the system pressure to ultra-high vacuum (UHV) pressures to remove residual water vapor and oxygen in the system, and finally to raise the heads back up to process temperature. Rotation of the substrate also may also be needed when switching between layouts.

Another potential drawback of convention OVJP deposition system architecture is that, to deliver carrier gas and organic material vapor to the required large numbers of print heads, the material sources should be relatively large and, therefore, should be located some distance away from the heads and typically outside the vacuum chamber or similar enclosure. The larger the distance between the sources and the print head, the more challenging it becomes to avoid cold spots, associated condensation, and other undesirable effects. Uniform gas and delivery of organic material vapor to multiple prints heads concurrently is also a challenge.

Finally, the length of the nozzles of the print dies used in the conventional system architecture is limited to relatively short sizes as a consequence of the die design, which in turn may limit the achievable throughput of the system.

Embodiments disclosed herein address these and other shortcomings of prior OVJP systems. Features provided by the present disclosure include bi-directional relative motion of the substrate and/or the OVJP print heads; independent alignment and/or real-time position adjustment of individual print heads; multi-die type print bar configurations, facilitating model change and MMG processing; dedicated proximity sources for each print head; print die designs and arrangements with longer apertures; and print head designs accommodating new print die configurations.

Embodiments disclosed herein may reduce the system complexity by reducing the number of print heads required to deposit pixels and pixel-type structures on a substrate, for a comparable or same-size substrate. Embodiments that achieve such a reduction may include embodiments having one or more individual print heads or one or more print bars carrying multiple print heads. A reduction in the number of print heads implies that relative motion of the print heads and the substrate can no longer be in just one direction, as in a conventional architecture as shown in FIG. 3, because the print heads no longer extend across the entire width of the substrate. In some embodiments, the print heads may be movable relative to the substrate in two dimensions. As disclosed herein, relative motion may be provided both in the direction of movement 330 as shown in FIG. 3, referred to herein as the scan direction or Y direction (typically parallel to the short edge of the substrate panel) and in the X or "step" direction that is perpendicular to the scan direction (and typically parallel to the long edge of the substrate panel). The stage motion pattern for a single panel layout then may be scan motion in the Y direction (as in a conventional architecture as shown in FIG. 3) and step motion in the X direction. Further, since multiple scans typically will be used to print all the required lines, the stage responsible for the Y motion may have a significantly higher velocity than in the conventional architecture. Whereas conventional scan motion speeds typically from 10-50 mm/s, a two-100 mm head (per color) system would use a scan motion 16 x faster, i.e., in the range 150 - 750 mm/s.

In embodiments disclosed herein, one or more OVJP print bars (each including one or more OVJP print heads or print engines) are arranged over the float table holding the substrate, and the two are movable relative to one another in each of two horizontal dimensions, i.e., within one or more planes that are parallel to the substrate as it is positioned under the print bars. The relative motion may be achieved by allowing the float table to move in two perpendicular horizontal directions, i.e., freely within a plane parallel to the plane of the substate, while the OVJP print bars are fixed in place horizontally or are movable horizontally only for fine-grained movement to achieve precise alignment with the substrate. Alternatively, the float table may be movable in one horizontal direction while the print bars are movable through a full range of motion in a second horizontal direction perpendicular to the first, where the two horizontal directions define a plane parallel to the plane of the substrate. Generally, the arrangements disclosed herein include one or more OVJP print bars that include one or more OVJP print heads. As with conventional OVJP deposition systems, the OVJP print heads are configured to eject material to be deposited on a substrate in a jet, in a vertical direction toward a substrate (i.e., perpendicular or essentially perpendicular to the substrate). A PV table or "float table" may be arranged below the OVJP print heads to hold the substrate. As used herein, the substrate and/or PV table may be described as being arranged "below" the OVJP print heads if they are placed in the path of the jet of material ejected from the OVJP print heads, regardless of their orientation with respect to one another relative to the direction of gravity. That is, the print heads may eject material in an upward direction and the substrate disposed "above" the print heads relative to the direction of gravity. In such an arrangement the substrate is still considered to be disposed "below" the OVJP print heads as described herein.

FIG. 4 shows an embodiment in which the PV table moves in both X and Y directions below a static gantry as shown in FIG. 3, which holds multiple print heads. In this arrangement, a movable PV table 410 holds a substrate 305, as described with respect to FIG. 3. A print bar including one or more print heads 330 is disposed on a static gantry 320 as described with respect to FIG. 3. The PV table 410 is movable under the print heads 330 via a Y-stage track 450 as well as an X-stage track 475 which together allow for movement of the PV table 410 and the substrate 305 within a plane under the print heads 330. For example, the substrate may be moved in a first direction 310, which may be referred to as the "scan" direction, to a first position under the print heads 330 to begin deposition. The PV table may move through a set distance in the first direction 410, after which the PV table may move in a second direction 412, referred to as the "step" direction, a set distance, before reversing the first direction 410. In this way, the print heads may be held in a fixed or essentially fixed position while the process is repeated to form any number of parallel lines of any desired deposition on the substrate.

In this configuration, as in the arrangement of FIG. 3, the print heads 330 may move only in the vertical direction, i.e., toward and away from the substrate 305, for flight control and deposition start and stop. In some configurations, the position of the print bar and/or the print heads may be adjusted across a relatively short distance to provide fine alignment control as disclosed in further detail below. The fine alignment may be performed before deposition begins or during deposition, for example based on an alignment feedback loop that indicates the print heads are moving out of alignment during the deposition process. In this and the other configurations disclosed herein, the fly height may be controlled on a per-head or per-bar basis. That is, the height of each print head on each print bar may be adjustable independently of the other print heads on the same bar and the print heads on the other print bars, and/or the height of each print bar may be adjustable independently of the height of each other print bar. To accommodate the X-motion 412 of the PV table 410, the system shown in FIG. 4 may be significantly wider than a conventional architecture as shown in FIG. 3. For example, in a two-print-head arrangement, the system may be roughly 1.5x times the size of the corresponding arrangement in FIG. 3. As previously noted, the print heads in this arrangement may be included in print engines that are mounted on a relatively stationary gantry above the PV table.

FIG. 5A shows another arrangement in which the PV table 510 scans in the Y direction and the print heads step in the X direction. Such an arrangement may be referred to as a "split-axis" architecture. This arrangement may use the same Y-stage 350 for the PV table 510 as shown in FIG. 3. In contrast to the system of FIG. 4, the PV table moves in a single horizontal direction 310, while the print heads 530 (or print bars or print engines that include the print heads, as previously disclosed) are positioned on a print head stage 535 that moves in the second horizontal direction 575, thereby allowing the print heads 530 to be stepped in the X direction. As with the arrangements of FIGS. 3-4, the print heads and/or print bars also may move vertically toward the substrate via fly height controls as disclosed herein.

FIG. 5B shows a top view of another example of an arrangement in which the PV table scans in the Y direction and print engines step in the X direction, with independent rotational/theta control of each print engine. Each print engine can cover the entire width of the substrate in the X direction (vertically on the page). As shown, there may be multiple print engines that deposit on a single substrate panel at the same time for improved TACT. There also may be multiple stationary print gantries arranged along the Y direction as shown. Each print engine may actively control the vertical distance of the print engine above the substrate in the vertical (z) direction and/or the theta-Y rotation positioning. Offset fly height sensors in front of and behind the print die may be used to monitor

The system shown in FIGS. 5A-5B has roughly the same width as system shown in FIG. 3, but requires significant changes in the organic gas generation and/or distribution system. As such, the material sources may move in conjunction with the print heads 530, and/or gas distribution tubing used to transfer material to be deposited via the print heads 530 accommodates the motion of the heads relative to the sources. This can be done by means of bellows and other structures known in the art, though avoiding condensation and achieving ultra-high vacuum with this approach may be challenging. In some embodiments, connections such as those disclosed in US 63/339,839 filed May 9, 2022 and US 18/311,550 filed May 3, 2023 (Docket No. UDC-OVJP-1005-US), the disclosure of which is incorporated by reference in its entirety, may be used.

FIG. 6 shows an arrangement in which the print heads 530, which may be incorporated in print engines as previously disclosed, step in the X direction 575 on a print gantry 625 scanning in the Y direction 610, above a relatively stationary PV table. In terms of the physical architecture of the system, this arrangement may be the most radical departure from the conventional arrangement of FIG. 3. The challenges to organic gas distribution and scanning architecture are amplified more than the split axis case shown in FIG. 5 because, in contrast to the split-axis case in FIG. 5, the carrier gas and exhaust tubes will travel the length and width of the substrate as the gantry moves across the entire substrate, whereas they only need to move across the width of the substrate in split-axis operation. However, because the substrate on the PV table 610 is static, the system footprint may be significantly smaller.

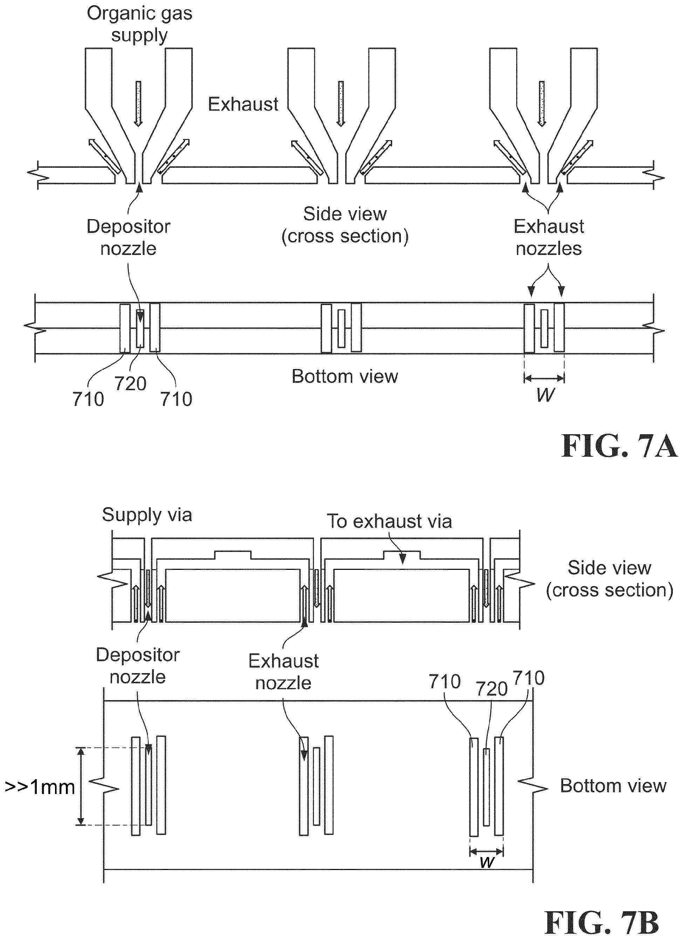

It may be convenient to describe the degree of motion of the print heads and/or the substrate in FIGS. 4-6 in terms of, and relative to, the dimensions of an individual OVJP print head. The OVJP print head dimensions provide a useful measure since the relative motion between the print heads and the substrate may be performed to allow for multiple sets of printed lines 355 to be deposited on the substrate. An OVJP print head typically includes multiple apertures on the bottom surface of a print die, which allow for material, exhaust, and, in some cases, confinement material flows. The die typically is a monolithic block of Si or a similar material, though other arrangements are possible. The die may be fabricated by etching the material flow channels in multiple layers of material which are then bonded to form the monolithic die. FIG. 7A shows an example of a high-level structure of an edge-on OVJP print die assembly. FIG. 7B shows the high-level structure of an in-plane print die assembly. In this case, the nozzles may be made much longer than in an edge-on arrangement, in which the length of the nozzles is limited by the thickness of the wafers from which the dies are made.

FIGS. 7A and 7B show segments of OVJP print dies that include three OVJP print heads. Each print head includes a depositor or delivery aperture 720 with exhaust apertures 710 on either side. Other OVJP print head arrangements may include a different number or arrangement of apertures, and/or different types of apertures. For example, confinement apertures to deliver confinement gas flows may be arranged on either side of the exhaust apertures 710. As another example, multiple offset delivery apertures 720 may be arranged between pairs of exhaust apertures 710. Each print head includes a set of apertures that function together to print one of the printed lines 355 as previously disclosed. That is, an OVJP print head may be defined by the apertures in the print die that work in conjunction to deposit a distinct printed region, typically an island or line of material, on the substrate. The OVJP print head may be characterized by its width W, measured across the apertures of the print head from each outermost edge of each outermost aperture, as shown in FIGS. 7A-7B. In the examples shown in FIGS. 7A-7B, the exhaust apertures 710 define the outermost edge of each side of each print head, meaning that W is measured from the left (outermost) edge of the left exhaust aperture to the right (outmost) edge of the right exhaust aperture. Where additional or different apertures are used in an OVJP print head, *W* is measured from the left outermost edge of the leftmost aperture to the right outermost edge of the rightmost aperture. For the OVJP print bar, print gantry, or PV table motion described herein, it may be desirable for the moving component(s) to be movable through a range of at least W in the associated direction(s), preferably at least 2W, 5W, 10W, or more. Conversely, where a component is described as "fixed" in a particular horizontal direction, the component may be unmovable in that direction or only movable through a *de minimis* amount, or it may be movable through a distance of less than W, for example to make fine-grained alignment adjustments. For example, in the arrangement shown in FIG. 4, a print bar or static gantry 320 may be fixed in place, while the OVJP print heads 330 may be movable through a distance of not more than W in one or more horizontal directions to allow for fine-grained alignment control. It may not be necessary for the print heads (or, in other arrangements, similar components that are movable only for precision alignment purposes) to be adjustable over a distance of more than *W*, since *W* is sufficient to allow for positioning of the OVJP print head within any portion of the "target" region corresponding to a single print head. In an arrangement such as FIG. 4, the print heads may be movable through a distance of not more than *W* in each of the directions 310, 412 corresponding to the available motion of the PV table 410. The PV table itself may be movable through a distance of *W*, 2*W*, 5*W*, 10*W*, or more to allow for deposition by the print heads across a large portion of the substrate. In some arrangements, the PV table may be movable in each direction through a distance corresponding to the same dimension of the substrate on which material will be deposited. That is, the PV table may be movable in the Y direction 310 across a distance at least equal to the Y dimension of substrates to be processed, and in the X direction 412 across a distance at least equal to the X dimension of the substrates. Typically the PV table will not need to move through a distance in the X direction 412 more than the X dimension of the substrate or slightly larger since the print heads 330 often will span the full width of the substrate, but in some arrangements, the PV table 410 may be movable through a distance of up to twice the substrate X dimension.

As another example, in an arrangement as shown in FIGS. 5A-5B, the PV table may move through a distance of at least *W,* 2*W,* 5*W,* 10*W*, in the Y direction 310, or it may be movable through a distance corresponding to the substrate Y dimension, or 2x, 3x, 4x, 5x of the substrate Y dimension or more. The print head stage 535 may be movable through a distance of at least *W*, 2*W*, 5*W*, 10*W*, in the X direction 575, thereby allowing for movement of the print heads 530 in the X direction. Typically the print head stage will not need to be movable through more than the substrate X dimension or slightly farther, since the print heads 530 generally will span the full width of the substrate.

As another example, in the arrangement of FIG. 6, the PV table may be movable in two horizontal dimensions 575, 610 only through a distance of up to *W* for precision alignment. The print gantry 625 or print heads 530 may be movable through a distance of *W, 2W, 3W, 4W, 5W, 10W* in one dimension 575, and through a distance at least equal to the substrate Y dimension or 2x the Y dimension in the other horizontal direction 610.

In some arrangements, a print bar or print bar gantry may be movable through a larger distance, such as of *W, 2W, 3W, 4W, 5W, 10W* or more, while the print heads on the print bar are movable through a distance of not more than W in one or two horizontal directions to allow for fine-grained positioning and alignment, either relative to the substrate/PV table or each other. The print heads also may be rotatable as disclosed herein to allow for precise alignment.

More generally, OVJP print heads also may be adjustable for additional alignment with the substrate, independently of the coarse overall movement of the OVJP print heads and/or the PV table. In a conventional OVJP architecture, the rotation and X-position of individual print heads must be adjusted during system set up. This adjustment typically requires a complex, high precision alignment procedure and corresponding equipment. One system to perform such an alignment is a configuration station, which includes a gantry on which the print bars carrying the print heads are mounted, a high-resolution sensor such as a digital camera that moves underneath the heads and measures the position and rotation of the individual print die, and high precision adjustment features for each head. FIG. 3 shows an example of such a system used in a conventional OVJP deposition architecture. Adjustment can either be done manually or automatically, using data from the position sensors as feedback. Following alignment, the head rotations and X-positions are fixed, and any residual error in the relative position and rotation of the print heads may be reflected in the position of the printed lines relative to the pixels on the display backplanes.

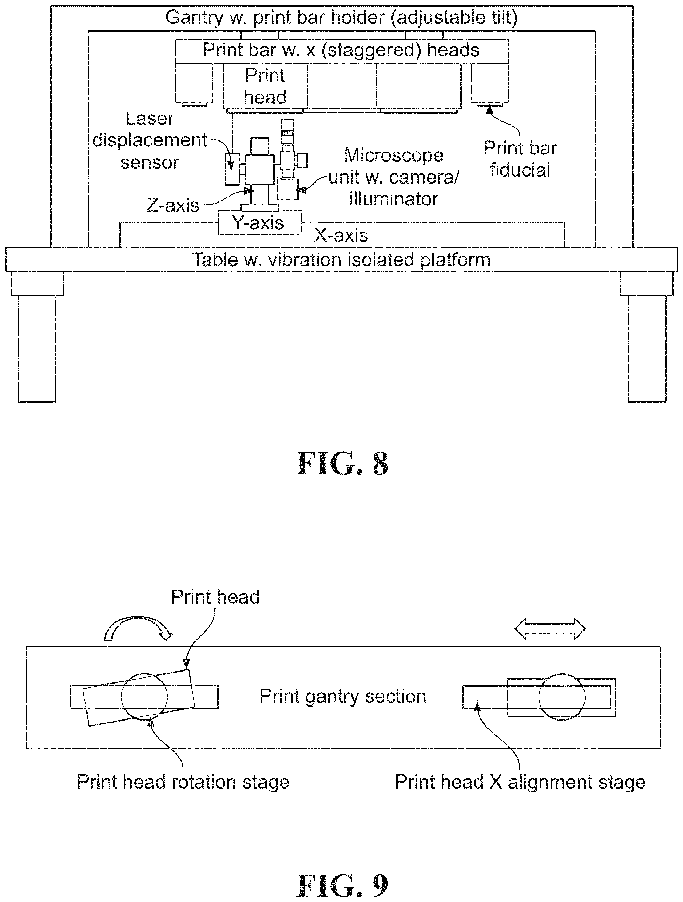

A benefit of embodiments disclosed herein is that the reduction in the number of heads can avoid such complex alignment schemes, especially in the case of individually-controlled print heads. In the case of print bars where multiple print heads are controlled as a unit, the heads in each bar may be pre-aligned to each other before the bar as a whole is aligned. Alignment in embodiments disclosed herein may be performed through independent controls for alignment in the X direction and rotation control through an angle θ for each print head, as shown in FIG.9. The added system complexity is much lower than it would have been in the conventional system architecture. Such alignment may correspond to the fine-grained alignment control as previously disclosed.

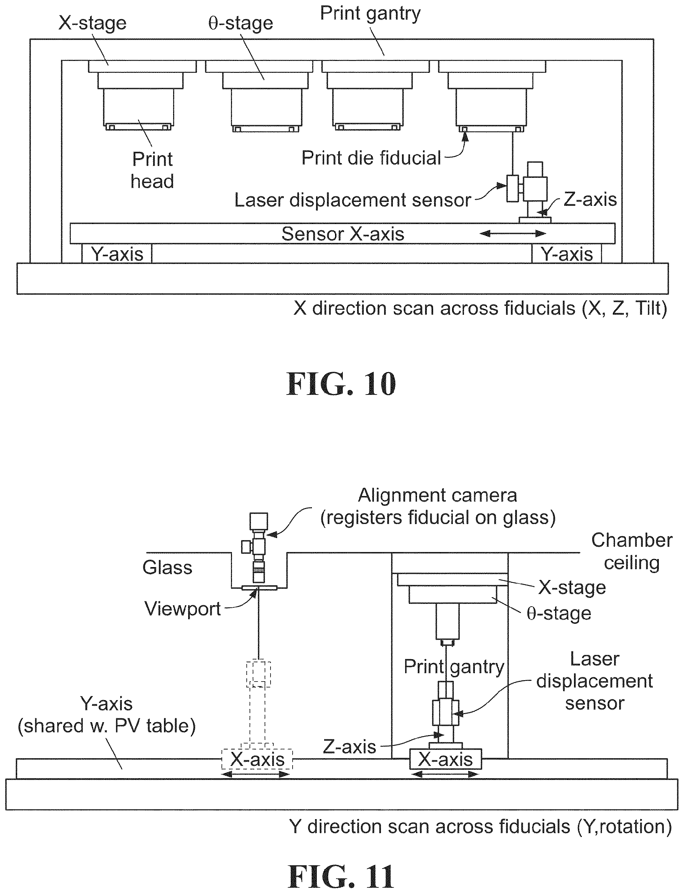

Alignment of the print heads to one other may be achieved through use of a sensor configured to detect fiducials on the print die. Optical sensors, in particular triangulation, interferometric or chromatic confocal sensors, may be best suited for this purpose. The sensor may be installed on a stage that moves in the X direction along which the print heads are oriented, as shown in FIG. 10. In the fixed gantry/moving PV table arrangement of FIG. 4 and the split axis architectures of FIGS. 5A-5B as disclosed herein, this axis may itself be mounted on the table scan/Y axis, while it can be fixed in a moving gantry/fixed table arrangement such as shown in FIG. 6. Moving the sensor along the print heads to the detect the fiducials allows determination of the X-position of the die, based on which further alignment adjustments can be made. Moving across the print head fiducials in the Y directions allows determination of the print head rotation, which can similarly be adjusted.

In operation of the systems disclosed herein, X-positions and rotations of the print heads may be globally adjusted based on the location and orientation of the substrate. The latter may be detected using, for example, high resolution alignment cameras that detect the position of fiducials on either side of the substrate. To tie the position of the print heads (or print bar as a whole) to that of the substrate, the print head alignment sensor may be imaged using the alignment cameras, as illustrated in FIG. 11. In the moving table and split axis architecture of FIGS. 4 and 5, in which the alignment cameras are typically located in a fixed location outside the system's vacuum enclosure, this may be achieved by moving the sensors to the X, Y location of the camera and capturing the location of the sensor light spot. To register the print die sensor position in the moving gantry architecture of FIG. 6, the cameras may be moved in the Y direction. The moving cameras may be located outside the vacuum chamber in which the OVJP system is operated, though this may require a separate stage and larger view ports in the chamber. Alternatively, the cameras may be located inside the vacuum chamber and be mounted on, and moving with, the gantry, for example. However, in such an arrangement this can make reaching ultra-high vacuum (UHV) conditions more challenging.

The individual adjustment capability disclosed herein not only allows each print head and/or bar and/or print engine to be aligned to the substrate (or features on the substrate such as a backplane) using the global substrate fiducials at initial alignment, but it can also enable real-time corrections to the alignment, for example using the edges of the substrate panel(s) as a reference. The latter allows for compensation of stage errors such as straightness, though this can also be done using metrology-based look-up tables. Detection of the panel edges can also be done using high resolution cameras. Furthermore, with the individual print head/bar adjustment capability in the new system architecture, any realignment of the print head position may be performed without braking vacuum.

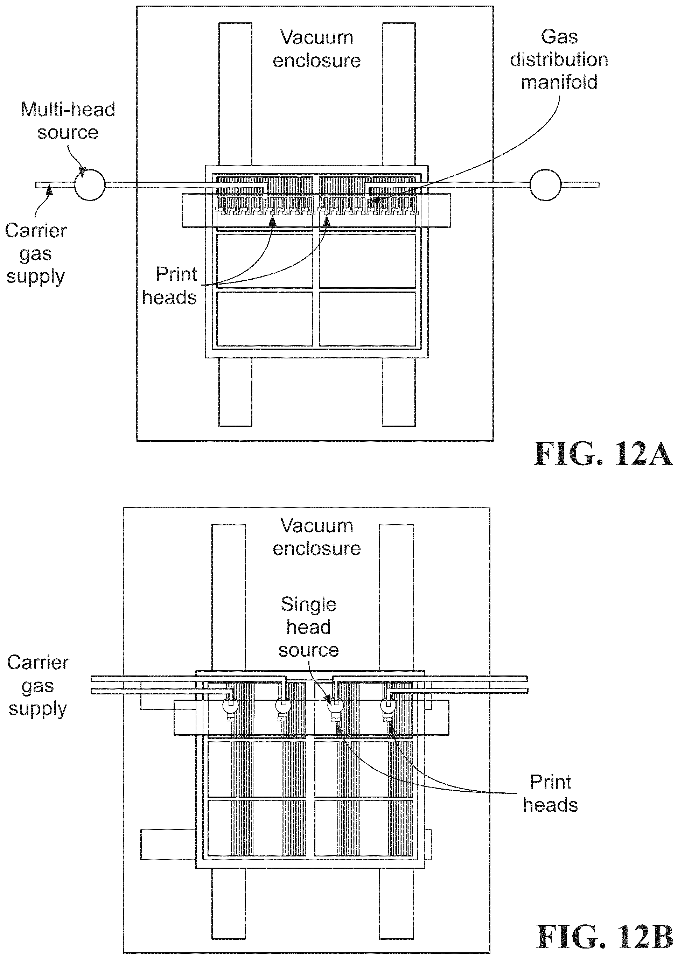

Because embodiments disclosed herein may use a significantly lower number of print heads than a conventional OVJP system, it is viable to use dedicated sublimation sources for each individually-controlled print head or bar. Such sources may be much more compact than those used in a conventional OVJP system architecture, and because a dedicated-source configuration requires less or no flow splitting, the sources also may be located closer to the print heads and the gas delivery requires fewer or no bends. This in turn reduces the likelihood of dead zones, cold spots and/or condensation/particulation that may result from them. FIGS. 12A and 12B illustrate differences between the gas distribution in conventional architecture (FIG. 12A) and a dedicated source configuration usable with embodiments disclosed herein (FIG. 12B). Notably, no gas distribution manifold is required, and each print head or print bar has a dedicated material source that provides material to be deposited only to the print head or print bar to which the source is connected. Compact sublimation sources as shown in FIG. 12B also are more amenable to moving in conjunction with the print heads which they are supplying. Accordingly, some configurations may use sources that are physically integrated with their respective printheads, i.e., residing in the same vacuum enclosure as the print heads and not requiring run lines, bellows, or the like between the material sources and the associated print heads. If the sources cannot be located inside the vacuum enclosure, a preferred configuration is one based on static sources, especially for depositions where a sustained UHV environment is required. (Gas feedthroughs accommodating source motion will likely not be able to meet this requirement). This also implies that the gas line connecting the sources to the printhead should have a section with sufficient flexibility to accommodate the motion of the print head/bar on the vacuum side of the enclosure. That is, each gas line should have sufficient flexibility to correspond to the direction(s) and maximum distance(s) of motion of the associated print bar or print head. As previously disclosed, such motion may be measured in terms of the width W of the associated OVJP print heads and/or the edge dimensions of the substrate being processed. In some configurations, individual bellows may be used, though avoiding dead zone and hermicity over the required length may be challenging for some materials and process parameters. A moving gantry/static substrate configuration as shown in FIG.4 may prefer to use sources integrated into the print heads/bars. Moving sourced located in the vacuum enclosure also should have vacuum-side flexibility in the carrier gas supply lines, but temperature uniformity over these lines is not as critical. In both cases (moving heads with integrated, moving sources located in the vacuum chamber or static sources located on the outside), the flexible lines may be placed in a separate, differentially pumped enclosure, such as described in U.S. Patent No. 10,566,534, the disclosure of which is incorporated by reference in its entirety.

Embodiments disclosed herein also may allow for use of print bars suitable for printing multiple display sizes. Because the nozzle pitch in a conventional OVJP arrangement typically matches the pixel pitch of the display backplane on which it is meant to deposit printed OLED lines, in a conventional system architecture, switching between different single panel size layouts generally involves exchanging all the print heads in the system. More specifically, it is typically required to swap entire print bars carrying print heads with one print die type, with print bars carrying print heads with another print die type. This may be avoided by using redundant gantries having print heads of different types, in which case the gas supply must be switched from one type of print head to the other when changing layouts. Switching between layouts with different panel orientations (portrait vs. landscape) also requires rotation of the glass substrate, so the system must be designed to accommodate both glass orientations.

In embodiments disclosed herein, the print gantry may carry print heads dedicated to different panel sizes. Switching a common source from one type of print head to another is also possible but at the cost of increased time. The print heads that are not used for printing may be lifted above the lift-off height (i.e., the gap above which no deposition occurs; typically around 200 µm). Unused, lifted print heads may move in conjunction with the active print head in the same fashion as if they were being used for deposition. As mentioned before, each head may have a dedicated material source. In another arrangement, the system may be switched between different types of print heads by "parking" unused heads in a dedicated area on one or more sides of the gantry. In contrast to conventional systems, witching between layouts with different orientations does not necessarily require glass rotation. Instead, the print heads for the rotated layouts and the scan direction may simply be rotated by 90 degrees.

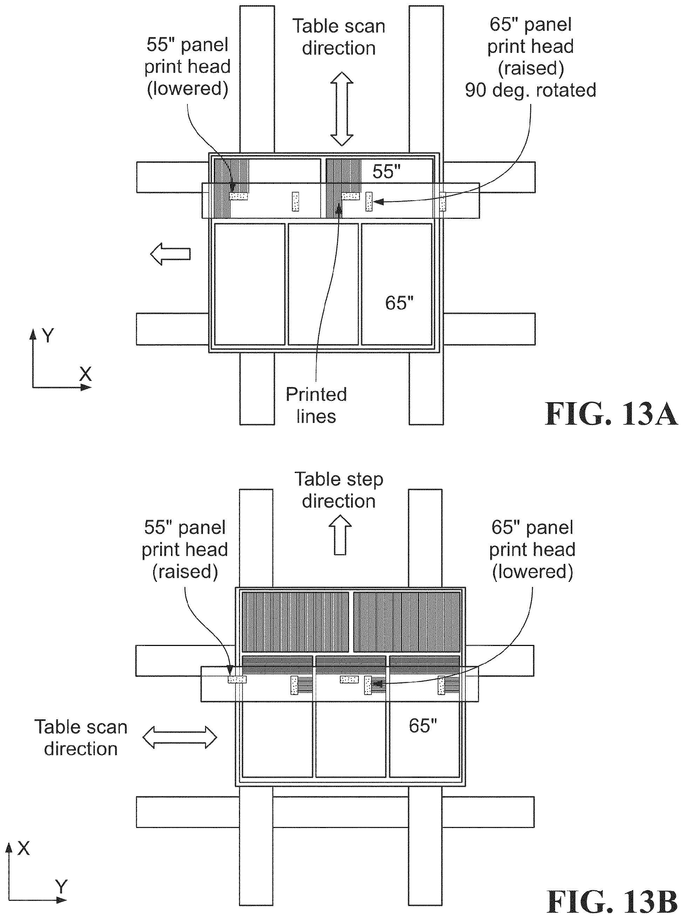

Multi-Model Glass (MMG) layouts, i.e., layouts that use multiple panel types on a common substrate, are intended to optimize substrate utilization. MMG layouts may be processed with the embodiments disclosed herein in a similar fashion, as shown in FIGS. 13A-13B. In this example, material is deposited on an MMG substrate layout with two differently-oriented panel types. The example in FIGS. 13A-13B shows a set of landscape-oriented 55" panels and a set of portrait-oriented 65" panels. FIG. 13A shows the trajectory used to print the 55" panel, in which the PV table scans back and forth in the longitudinal direction and steps in the lateral direction. FIG. 13B shows the trajectory for the 65" panel, in which the PV table scans back and forth in the lateral direction and steps in the longitudinal direction as shown. A similar process can be used for other substrate sizes, layouts, and MMG arrangements. Print gantries may carry different print head types, oriented according to the corresponding panel orientation on which they will deposit material. Different panel types typically are processed sequentially, with the unused heads being lifted above the lift-off height. During the transition between different panel types, in principle the print heads used for the first panel type must be lifted, and the print heads used for the second type of panels must be lowered, within the space between the different panel types. This may be avoided, for example, if excess printed material is removed by, for example, photolithography (masking followed by selective etching). Similar approaches may be used to remove unwanted printed lines between panels of a same type, or at the beginning or end of a print scan.

One challenge in using embodiments disclosed herein instead of a conventional OVJP deposition system relates to the throughput. To sustain a much higher stage scan speed, Vscan, of, for example, 16x a conventional scan speed, either the growth rate R or the length Ldep of the depositor nozzles should be increased, since the height of the deposited line Hline is equal to R*(Ldep/Vscan). The deposition rate mainly depends on the temperature used to sublimate the material being deposited, but this temperature typically cannot be increased to arbitrarily high values because the material will dissociate beyond a certain threshold, resulting in a damaged or otherwise unusable deposition. Therefore, the most effective way to accommodate the increased scan speed without requiring unrealistic source temperatures is to increase the length of the depositor nozzles, i.e., the Y-axis dimension of the print head apertures. For example, the print head nozzle apertures may be increased by a factor of 16 to compensate.

Various OVJP print head nozzle designs may be used with embodiments disclosed herein. Among those, the most common are the edge-on and the in-plane designs, such as those described with respect to FIGS. 7A and 7B. Edge-on dies are made from a vertically oriented stack of multiple bonded plates in which gas distribution channels, leading to apertures located along the short edge of the dies, are defined in the plane of the die. Such arrangements typically are fabricated using photolithography, though other fabrication methods, such as laser ablation, are also possible. In edge-on dies, the length of the nozzles is dictated by the thickness of the individual die; for Si die this corresponds to the thickness of the wafer in which they are made which typically is 0.5 mm. In a conventional OVJP system, dies made from two individual dies are typically used, with a total depositor length of about 400 µm. A substantial increase in the nozzle length of edge-on dies leads to a corresponding increase of the number of individual dies in the stack to maintain the same growth rate and throughput as in conventional architecture, which may cause issues related to die alignment and bonding reliability. An edge-on die assembly including 3 individual dies may be used, but may offer limited room for throughput improvement (1.5x relative to the conventional 2-die assembly edge-on assembly for the same source conditions).

In-plane dies also consist of multiple bonded plates, typically 2-3, in which gas distribution channels are defined. However, in contrast to edge-on dies, the stack is horizontally oriented and the nozzles consist of orifices in the face of the die as shown in FIG. 7B. This may allow for a more straightforward fabrication of long depositor nozzles. For example, 1, 2, 3, 4, 5, or 6 mm long delivery apertures are achievable using lithographic techniques.

One possible issue with longer print head apertures is that the gas supply from the chamber ambient to the exhaust apertures, typically arranged on either side of the depositor aperture, may not be uniform along the width (short axis) of the print head. Due to the relatively large width of the die, it is possible that less chamber gas (typically an inert gas such as N2, Ar or the like) reaches the center of the die, i.e., the exhaust channels. Because the exhaust gas is responsible for confinement of the deposition, this non-uniformity may lead to an undesirable increase in line width. One way to mitigate this issue is to use an additional confinement (or "make-up") gas supply orifice between adjacent print head aperture groups, as shown in FIG. 14. This shows an arrangement for an in-plane die, but similar arrangements may be used for edge-on dies. The additional gas flow supplied by these orifices may restore the uniformity of the gas flow supplied to the exhaust nozzles. In an arrangement using apertures disposed between the sets of print head apertures, W may still be measured across the delivery and exhaust apertures, excluding the intervening confinement / make-up apertures, because the make-up apertures are not associated with only a single deposited feature. That is, each make-up aperture affects the shape and flow of material for two delivery apertures. Further, the distance through which an individual print head or print bar needs to move to achieve precise alignment is not affected by the presence of the make-up apertures, because they will be properly aligned when the surrounding print head apertures are properly aligned.

Another way of to address confinement uniformity issues is to use additional make up-up gas jets in the "confinement plate" as shown in FIG. 15. The confinement plate is a plate with active cooling channels, arranged at the bottom of the print head and surrounding the print heads, which enables control of the temperature of the substrate. However, regardless of which arrangement is used, the additional gas will pass through the print head assembly and thus will be heated along the path, as opposed to other configurations in which the confinement gas is provided directly by the chamber, such as via ambient gas and pressure configurations. Accordingly, this may impact temperature of the substrate, in which case it may be preferred to include additional cooling or other temperature controls in the PV table or substrate holder.

Print dies generally may be integrated into the print heads by means of a print manifold. These manifolds hermetically convey and distribute organic gases between the die and the system gas lines (connected to the sublimation sources on one side and the exhaust assembly on the other), and keep the gas temperature within an appropriate range to prevent condensation (on the low end) or decomposition (on the high end). Manifolds therefore typically include channel structures that ensure that the organic gases are evenly distributed to and from the die, as well heating structures that can be controlled with high accuracy. Manifolds should be made of materials that are compatible with OVJP process temperatures of 500 C and higher, should have high thermal conductivity, and should have a coefficient of thermal expansion that is a good match to the die material. Appropriate materials for use with the embodiments disclosed herein include W, Mo, AIN and (poly-)Si.

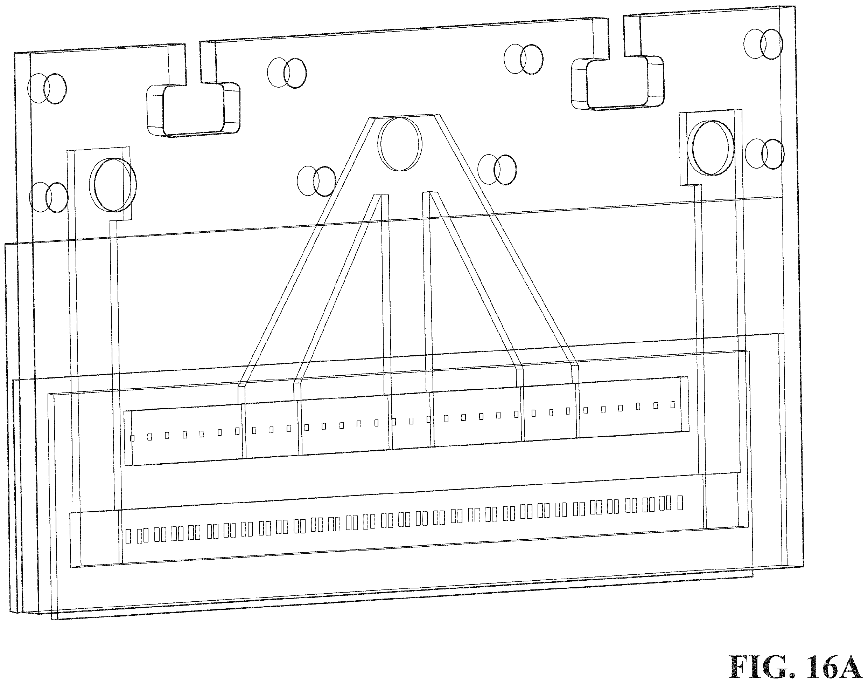

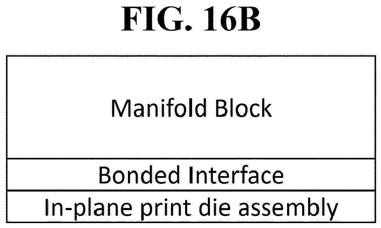

The manifolds used with the edge-on die assembly attach to both faces of the die in order to facilitate uniform heating of the organic gases and to ensure proper gas interfacing if delivery inlet and exhaust outlet vias are on opposite sides of the print die, as shown in FIG. 16A. Hermetic attachment of the die to the manifold may be achieved via mechanical clamping and sealing or bonding techniques such as brazing or glass-frit bonding. In the case of in-plane dies, the manifold attaches only to one side, more specifically the top face, of the die, as shown in FIG. 16B. In this case, die clamping is not possible as the clamps would interfere with the ability to position the head at small gaps above the substrate, and thus the attachment will rely on bonding techniques.

As previously disclosed, OVJP print bars and arrangements disclosed herein may use fewer print heads than conventional OVJP deposition systems. For example, an OVJP print bar or set of print bars used in any of the systems shown in FIGS. 4-6 may use a number of print bars sufficient to deposit material over half of the substrate in a single pass, i.e., without movement in the step direction. Where printed lines are desired over the entire substrate, such an arrangement may do so by performing two scans, with a step distance between them equal to the width of the material deposited in each scan. The specific number of print heads may be arranged over multiple print bars, or each print bar may have the same number of print heads sufficient to deposit over half of the substrate.

Embodiments disclosed herein may include a cooled particle filter as a part of the print engine that removes organic material before the exhaust line between the print engine and vacuum source.

It is understood that the various embodiments described herein are by way of example only, and are not intended to limit the scope of the invention. For example, many of the materials and structures described herein may be substituted with other materials and structures without deviating from the spirit of the invention. The present invention as claimed may therefore include variations from the particular examples and preferred embodiments described herein, as will be apparent to one of skill in the art. It is understood that various theories as to why the invention works are not intended to be limiting.

In the following numbered aspects of the present invention are disclosed.
1. An organic vapor jet printing (OVJP) system comprising:
   one or more OVJP print bars, each comprising one or more OVJP print heads configured to eject material substantially in a primary vertical direction toward a substrate, each OVJP print head comprising a plurality of apertures disposed across a horizontal distance *W* on a surface of the print head facing the substrate; and
   a float table configured to hold the substrate below the one or more OVJP print bars;
   wherein the float table is movable through a distance of at least W in each of two horizontal dimensions in a plane perpendicular to the primary vertical direction during operation of the system.
2. The OVJP device/system of aspect 1, wherein the one or more OVJP print bars are fixed in place horizontally.
3. The OVJP device/system of aspect 2, wherein the one or more OVJP print heads are movable through a distance of not more than W in the two horizontal dimensions.
4. The OVJP device/system of aspect 1, wherein the one or more OVJP print bars are movable through a distance of not more than W in the two horizontal dimensions.
5. The OVJP device/system of aspect 1, wherein the float table is movable through a distance of at least 10W in each of the two horizontal dimensions.
6. The OVJP device/system of aspect 5, wherein the float table is movable through a distance equal to at least twice an edge dimension of the substrate in one of the two horizontal dimensions that is parallel to the direction of motion as the substrate is moved through the OVJP device during deposition of material on the substrate.
7. The OVJP device/system of aspect 1, wherein the float table is movable through a distance at least equal to an edge dimension of the substrate in each of the two horizontal dimensions.
8. The OVJP system of aspect 1, wherein the float table comprises a pressure-vacuum (PV) float table.
9. The OVJP system of aspect 1, wherein:
   a height of each of the plurality of OVJP print bars is adjustable, and/or
   a height of the one or more OVJP print heads on each OVJP print bar of the plurality of OVJP print bars is adjustable independently of the height of the each OVJP print bar.
10. The OVJP device/system of aspect 1, wherein the one or more OVJP print bars comprise a total number of OVJP print heads sufficient to deposit material over not more than 50% of the substrate.
11. The OVJP device/system of aspect 1, wherein each of the OVJP print bars comprises a total number of OVJP print heads sufficient to deposit material over not more than 50% of the substrate.
12. The OVJP device/system of aspect 1, wherein an angle of each OVJP print head relative to the substrate and a position of each print head in a dimension perpendicular to the primary direction of motion of the float table is independently controllable.
13. The OVJP device/system of aspect 1, further comprising a sensor arranged and configured to determine a relative position of the substrate below the OVJP print bars.
14. The OVJP device/system of aspect 13, further comprising a controller arranged and configured to adjust a position and/or an angle of each of the OVJP print head based on data obtained by the sensor.
15. The OVJP device/system of aspect 1, wherein each OVJP print head comprises a material source chamber integrally connected to the OVJP print head.
16. The OVJP device/system of aspect 1, wherein each OVJP print head comprises a cooled particle filter arranged and configured to remove organic material from a flow of material below the one or more OVJP print bars before the flow of material is removed via one or more exhausts.
17. The OVJP device/system of aspect 1, wherein at least one of the plurality of apertures in each OVJP print head comprises a delivery aperture having a minimum length of 2 mm.
18. The OVJP device/system of aspect 1, further comprising a manifold hermetically sealed to the one or more OVJP print heads to provide source materials to the one or more OVJP print heads.
19. An organic vapor jet printing (OVJP) system comprising:
   one or more OVJP print bars, each comprising one or more OVJP print heads configured to eject material substantially in a primary vertical direction toward a substrate, each OVJP print head comprising a plurality of apertures disposed across a horizontal distance *W* on a surface of the print head facing the substrate; and
   a float table configured to hold the substrate below the one or more OVJP print bars;
   wherein the float table is movable in a first dimension in a plane perpendicular to the primary vertical direction during operation of the system; and
   wherein the one or more OVJP print bars are movable through a distance at least equal to W in a second dimension perpendicular to the first dimension and perpendicular to the primary vertical direction.
20. The OVJP device/system of aspect 19, wherein the first dimension is parallel to the primary direction of movement of the float table below the OVJP print heads.
21. The OVJP device/system of aspect 19, wherein the first dimension is perpendicular to the primary direction of movement of the float table below the OVJP print heads.
22. The OVJP system of aspect 19, wherein the float table comprises a pressure-vacuum (PV) float table.
23. The OVJP system of aspect 19, wherein:
   a height of each of the plurality of OVJP print bars is adjustable, and/or
   a height of the one or more OVJP print heads on each OVJP print bar of the plurality of OVJP print bars is adjustable independently of the height of the each OVJP print bar.
24. The OVJP device/system of aspect 19, wherein the one or more OVJP print bars comprise a total number of OVJP print heads sufficient to deposit material over not more than 50% of the substrate.
25. The OVJP device/system of aspect 19, wherein each of the OVJP print bars comprises a total number of OVJP print heads sufficient to deposit material over not more than 50% of the substrate.
26. The OVJP device/system of aspect 19, wherein an angle of each OVJP print head relative to the substrate and a position of each print head in a dimension perpendicular to the primary direction of motion of the float table is independently controllable.
27. The OVJP device/system of aspect 19, further comprising a sensor arranged and configured to determine a relative position of the substrate below the OVJP print bars.
28. The OVJP device/system of aspect 27, further comprising a controller arranged and configured to adjust a position and/or an angle of each of the OVJP print head based on data obtained by the sensor.
29. The OVJP device/system of aspect 19, wherein each OVJP print head comprises a material source chamber integrally connected to the OVJP print head.
30. The OVJP device/system of aspect 19, wherein each OVJP print head comprises a cooled particle filter arranged and configured to remove organic material from a flow of material below the one or more OVJP print bars before the flow of material is removed via one or more exhausts.
31. The OVJP device/system of aspect 19, wherein at least one of the plurality of apertures in each OVJP print head comprises a delivery aperture having a minimum length of 2 mm.
32. The OVJP device/system of aspect 19, further comprising a manifold hermetically sealed to the one or more OVJP print heads to provide source materials to the one or more OVJP print heads.

## Claims

1. An organic vapor jet printing (OVJP) system comprising:
one or more OVJP print bars, each comprising one or more OVJP print heads configured to eject material substantially in a primary vertical direction toward a substrate, each OVJP print head comprising a plurality of apertures disposed across a horizontal distance *W* on a surface of the print head facing the substrate; and
a float table configured to hold the substrate below the one or more OVJP print bars;
wherein the float table is movable through a distance of at least *W* in each of two horizontal dimensions in a plane perpendicular to the primary vertical direction during operation of the system.

2. The OVJP device of claim 1, wherein the one or more OVJP print bars are fixed in place horizontally.

3. The OVJP device of any of claims 1-2, wherein the one or more OVJP print heads are movable through a distance of not more than W in the two horizontal dimensions.

4. The OVJP device of any of the preceding claims, wherein the float table is movable through a distance of at least 10W in each of the two horizontal dimensions.

5. The OVJP device of claim 4, wherein the float table is movable through a distance equal to at least twice an edge dimension of the substrate in one of the two horizontal dimensions that is parallel to the direction of motion as the substrate is moved through the OVJP device during deposition of material on the substrate.

6. The OVJP device of claim 1, wherein the float table is movable through a distance at least equal to an edge dimension of the substrate in each of the two horizontal dimensions.

7. An organic vapor jet printing (OVJP) system comprising:
one or more OVJP print bars, each comprising one or more OVJP print heads configured to eject material substantially in a primary vertical direction toward a substrate, each OVJP print head comprising a plurality of apertures disposed across a horizontal distance *W* on a surface of the print head facing the substrate; and
a float table configured to hold the substrate below the one or more OVJP print bars;
wherein the float table is movable in a first dimension in a plane perpendicular to the primary vertical direction during operation of the system; and
wherein the one or more OVJP print bars are movable through a distance at least equal to W in a second dimension perpendicular to the first dimension and perpendicular to the primary vertical direction.

8. The OVJP device of claim 7, wherein the first dimension is parallel to a primary direction of movement of the float table below the OVJP print heads.

9. The OVJP device of claim 7, wherein the first dimension is perpendicular a primary direction of movement of the float table below the OVJP print heads.

10. The OVJP system of either of claims 1 and 7, wherein:
a height of each of the plurality of OVJP print bars is adjustable, and/or
a height of the one or more OVJP print heads on each OVJP print bar of the plurality of OVJP print bars is adjustable independently of the height of the each OVJP print bar.

11. The OVJP device of either of claims 1 and 7, wherein the one or more OVJP print bars comprise a total number of OVJP print heads sufficient to deposit material over not more than 50% of the substrate.

12. The OVJP device of either of claims 1 and 7, further comprising:
a sensor arranged and configured to determine a relative position of the substrate below the OVJP print bars; and
a controller arranged and configured to adjust a position and/or an angle of each of the OVJP print head based on data obtained by the sensor.

13. The OVJP device of either of claims 1 and 7, wherein each OVJP print head comprises a material source chamber integrally connected to the OVJP print head.

14. The OVJP device of either of claims 1 and 7, wherein at least one of the plurality of apertures in each OVJP print head comprises a delivery aperture having a minimum length of 2 mm.

15. The OVJP device of either of claims 1 and 7, further comprising a manifold hermetically sealed to the one or more OVJP print heads to provide source materials to the one or more OVJP print heads.
